# EUROPEAN PATENT APPLICATION

(11) **EP 4 675 019 A1**
(43) Date of publication of application: **07.01.2026**
(21) Application number: 24763825.7
(22) Date of filing: 26.02.2024
(51) Int. Cl.: C30B 29/38, C30B 25/18, H01L 21/20, H01L 21/66

(54) **GALLIUM NITRIDE SUBSTRATE**

(30) Priority: 28.02.2023 JP 2023030253; 28.02.2023 JP 2023030254; 28.02.2023 JP 2023030255; 28.02.2023 JP 2023030257
(71) Applicant: MITSUBISHI CHEMICAL CORPORATION, Tokyo 100-8251 (JP)
(72) Inventor: ODANI Takafumi, Tokyo 100-8251 (JP); MIURA Akinori, Tokyo 100-8251 (JP); ENATSU Yuuki, Tokyo 100-8251 (JP); TATE Kenta, Tokyo 100-8251 (JP); TAKAKURA Tomoyuki, Tokyo 100-8251 (JP); TASHIRO Masayuki, Tokyo 100-8251 (JP)
(74) Representative: Hoffmann Eitle
(86) International application number: PCT/JP2024/006750
(87) International publication number: WO 2024/181345

(57) **Abstract**

The present invention relates to a gallium nitride substrate having a main surface inclined by 0° to 20° from a (0001) plane and having an area of 15 cm² or more. The main surface has a dislocation density of 5 × 10⁶ cm⁻² or less, and a number density of local strains in a crossed Nicols image obtained by a sensitive color method for the main surface is 0.5cm⁻² or less.

## Description

### TECHNICAL FIELD

The present invention relates to a gallium nitride (GaN) substrate.

### BACKGROUND ART

A GaN substrate obtained from a GaN crystal is used as a substrate for producing a laser diode (LD). Recently, GaN substrates have been considered promising as substrates for vertical power semiconductor devices (PDs).

As a GaN substrate for an LD or a GaN substrate for a vertical PD, a GaN substrate in which a dislocation density and an off-angle distribution are reduced in order to improve device performance is required.

Patent Literature 1 describes a method for obtaining a GaN crystal having a reduced dislocation density by using a hydride vapor phase epitaxy (HVPE) method. Patent Literature 2 describes a c-plane GaN substrate in which the fluctuation of an off-cut angle is inhibited obtained by using the HVPE method.

### CITATION LIST

### PATENT LITERATURE

Patent Literature 1: JP2020-125229A
Patent Literature 2: JP2021-031329A

### NON-PATENT LITERATURE

Non Patent Literature 1: Masayuki Fukuzawa, Dissertation, "Studies on Photoelasticity Evaluation of Compound Semiconductor", Kyoto Institute of Technology (1997)
Non Patent Literature 2: M.Fukuzawa, T.Chu, and M. Yamada, J.Soc.Mat.Sci., Japan., 51, 9, 966, (2002)
Non Patent Literature 3: M.Fukuzawa, R. Kashiwagi, and M.Yamada, Phys.Status Solidi C 8, No.2,432, (2011)

### SUMMARY OF INVENTION

### TECHNICAL PROBLEM

However, when the GaN crystal obtained according to a common production method using the HVPE method as described above is used as a c-plane GaN substrate for an LD, a yield during LD production decreases, and there is room for improvement.

Therefore, a main object of the present invention is to provide a GaN substrate capable of reducing deterioration in the yield during LD production when used as the c-plane GaN substrate for an LD.

### SOLUTION TO PROBLEM

As a result of intensive studies on the above problems, the present inventors have found that, as a first aspect and a second aspect, a decrease in yield is caused by strains locally present on a main surface of the GaN crystal, and have completed the present invention.

In addition, as a result of intensive studies on the above problems, the present inventors have found that, as a third aspect, the decrease in yield is caused by pits present on the main surface of the GaN crystal, and have completed the present invention.

Further, as a result of intensive studies on the above problems, the present inventors have found that, as a fourth aspect, one of the causes for the decrease in yield is a shape of the GaN substrate, and have completed the present invention.

Aspects of the present invention include the following GaN substrate.

### <First Aspect>

An aspect 1-1 of the present invention provides a gallium nitride substrate including a main surface inclined by 0° to 20° from a (0001) plane and having an area of 15 cm² or more, in which the main surface has a dislocation density of 5 × 10⁶ cm⁻² or less, and a number density of local strains in a crossed Nicols image obtained by a sensitive color method for the main surface is 0.5 counts · cm⁻² or less.

An aspect 1-2 of the present invention provides a gallium nitride substrate including a main surface inclined by 0° to 20° from a (0001) plane and having an area of 15 cm² or more, in which at least one 2.5 cm × 2.5 cm square lattice in which no local strain is observed can be found in a crossed Nicols image obtained by a sensitive color method for the main surface.

The gallium nitride substrate according to an aspect 1-3 of the present invention is directed to the gallium nitride substrate according to the aspect 1-1 or 1-2, in which when a normal direction of the main surface is defined as a z direction, and two directions perpendicular to the z direction and perpendicular to each other are defined as an x direction and a y direction, respectively, a fluctuation range of an x-direction component of an off-cut angle on a first line passing through a center of the main surface and extending in the x direction and a fluctuation range of a y - direction component of the off-cut angle on a second line passing through the center of the main surface and extending in the y direction are each 0.2 degrees or less within a section of a length of 40 mm.

The gallium nitride substrate according to an aspect 1-4 of the present invention is directed to the gallium nitride substrate according to any one of the aspects 1-1 to 1-3, in which one or more conditions regarding impurity concentrations are satisfied, the one or more conditions being selected from the following conditions (a) to (c):
condition (a) a Si concentration is 5 × 10¹⁶ atoms/cm³ or more,
condition (b) an O concentration is 3 × 10¹⁶ atoms/cm³ or less, and
condition (c) a H concentration is 1 × 10¹⁷ atoms/cm³ or less.

### <Second Aspect>

An aspect 2-1 of the present invention provides a gallium nitride substrate including a main surface inclined by 0° to 20° from a (0001) plane and having an area of 15 cm² or more, in which a maximum value of a strain evaluation value in the main surface is 1 × 10⁻⁴ or less, the strain evaluation value being calculated by a photoelasticity measurement for the main surface based on the following formula (1).
[Math. 1] $STRAIN EVALUATION VALUE : \left|{S}_{r}-{S}_{t}\right| = {\left[{\left({S}_{yy}-{S}_{xx}\right)}^{2}+{\left(2{S}_{xy}\right)}^{2}\right]}^{\frac{1}{2}}$

Each term in the formula (1) is represented by the following formulae (2) and (3).$\begin{matrix}\left|{S}_{yy}-{S}_{xx}\right| = \frac{λδ}{{πdn}_{0}^{3}} \left|\frac{cos 2 ϕ}{{p}_{11} - {p}_{12}}\right| \left(2\right) \\ 2 \left|{S}_{xy}\right| = \left|\left({S}_{yy}-{S}_{xx}\right) tan 2ψ\right| \left(3\right)\end{matrix}$

In the formula, δ and ψ represent a phase difference which is a birefringence amount derived from a strain and a principal axis azimuth angle, respectively, λ represents a light source wavelength of a photoelasticity measurement apparatus, d represents a sample thickness, n₀ represents a strain-free refractive index with respect to the light source wavelength, |p₁₁ - p₁₂| represents a photoelastic tensor component, and among these, λ, n₀, and |p₁₁ - p₁₂| satisfy the following conditions: $λ = 633 nm ;$ ${n}_{0} = 2.355 ;$ and $\left|{p}_{11}-{p}_{12}\right| = 0.13 .$

An aspect 2-2 of the present invention provides a gallium nitride substrate including a main surface inclined by 0° to 20° from a (0001) plane and having an area of 15 cm² or more, in which an area (S1) in which a strain evaluation value is 6 × 10⁻⁵ or more is 0.10% or less of an area of the entire main surface, the strain evaluation value being calculated by a photoelasticity measurement for the main surface based on the following formula (1).
[Math. 3] $STRAIN EVALUATION VALUE : \left|{S}_{r}-{S}_{t}\right| = {\left[{\left({S}_{yy}-{S}_{xx}\right)}^{2}+{\left(2{S}_{xy}\right)}^{2}\right]}^{\frac{1}{2}}$

Each term in the formula (1) is represented by the following formulae (2) and (3). $\begin{matrix}\left|{S}_{yy}-{S}_{xx}\right| = \frac{λδ}{{πdn}_{0}^{3}} \left|\frac{cos 2 ϕ}{{p}_{11} - {p}_{12}}\right| \left(2\right) \\ 2 \left|{S}_{xy}\right| = \left|\left({S}_{yy}-{S}_{xx}\right) tan 2ψ\right| \left(3\right)\end{matrix}$

In the formula, δ and ψ represent a phase difference which is a birefringence amount derived from a strain and a principal axis azimuth angle, respectively, λ represents a light source wavelength of a photoelasticity measurement apparatus, d represents a sample thickness, n₀ represents a strain-free refractive index with respect to the light source wavelength, |p₁₁ - p₁₂| represents a photoelastic tensor component, and among these, λ, n₀, and |p₁₁ - p₁₂| satisfy the following conditions: $λ = 633 nm ;$ ${n}_{0} = 2.355 ;$ and $\left|{p}_{11}-{p}_{12}\right| = 0.13 .$

An aspect 2-3 of the present invention provides a gallium nitride substrate including a main surface inclined by 0° to 20° from a (0001) plane and having an area of 15 cm² or more, in which a ratio (S1/S2) of an area (S1) in which a strain evaluation value is 6 × 10⁻⁵ or more to an area (S2) in which the strain evaluation value is 5 × 10⁻⁵ or more is 50% or less, the strain evaluation value being calculated by a photoelasticity measurement for the main surface based on the following formula (1).
[Math. 5] $STRAIN EVALUATION VALUE : \left|{S}_{r}-{S}_{t}\right| = {\left[{\left({S}_{yy}-{S}_{xx}\right)}^{2}+{\left(2 {S}_{xy}\right)}^{2}\right]}^{\frac{1}{2}}$

Each term in the formula (1) is represented by the following formulae (2) and (3). $\begin{matrix}\left|{S}_{yy}-{S}_{xx}\right| = \frac{λδ}{{πdn}_{0}^{3}} \left|\frac{cos 2 ϕ}{{p}_{11} - {p}_{12}}\right| \left(2\right) \\ 2 \left|{S}_{xy}\right| = \left|\left({S}_{yy}-{S}_{xx}\right)tan 2ψ\right| \left(3\right)\end{matrix}$

In the formula, δ and ψ represent a phase difference which is a birefringence amount derived from a strain and a principal axis azimuth angle, respectively, λ represents a light source wavelength of a photoelasticity measurement apparatus, d represents a sample thickness, n₀ represents a strain-free refractive index with respect to the light source wavelength, |p₁₁ - p₁₂| represents a photoelastic tensor component, and among these, λ, n₀, and |p₁₁ - p₁₂| satisfy the following conditions: $λ = 633 nm ;$ ${n}_{0} = 2.355 ;$ and $\left|{p}_{11}-{p}_{12}\right| = 0.13 .$

The gallium nitride substrate according to an aspect 2-4 of the present invention is directed to the gallium nitride substrate according to any one of the aspects 2-1 to 2-3, in which the main surface has a dislocation density of 5 × 10⁶ cm⁻² or less.

The gallium nitride substrate according to an aspect 2-5 of the present invention is directed to the gallium nitride substrate according to any one of the aspects 2-1 to 2-4, in which when a normal direction of the main surface is defined as a z direction, and two directions perpendicular to the z direction and perpendicular to each other are defined as an x direction and a y direction, respectively, a fluctuation range of an x-direction component of an off-cut angle on a first line passing through a center of the main surface and extending in the x direction and a fluctuation range of a y-direction component of the off-cut angle on a second line passing through the center of the main surface and extending in the y direction are each 0.2 degrees or less within a section of a length of 40 mm.

The gallium nitride substrate according to an aspect 2-6 of the present invention is directed to the gallium nitride substrate according to any one of the aspects 2-1 to 2-5, in which one or more conditions regarding impurity concentrations are satisfied, the one or more conditions being selected from the following conditions (a) to (c):
condition (a) a Si concentration is 5 × 10¹⁶ atoms/cm³ or more;
condition (b) an O concentration is 3 × 10¹⁶ atoms/cm³ or less, and
condition (c) a H concentration is 1 × 10¹⁷ atoms/cm³ or less.

### <Third Aspect>

An aspect 3-1 of the present invention provides a gallium nitride substrate including a main surface inclined by 0° to 20° from a (0001) plane and having an area of 15 cm² or more, in which a number density of pits in the main surface is less than 0.3 counts·cm⁻².

An aspect 3-2 of the present invention provides a gallium nitride substrate including a main surface inclined by 0° to 20° from a (0001) plane and having an area of 15 cm² or more, in which at least one 2.5 cm × 2.5 cm square lattice in which no pit is observed can be found on the main surface.

The gallium nitride substrate according to an aspect 3-3 of the present invention is directed to the gallium nitride substrate according to the aspect 3-1 or 3-2, in which the main surface has a dislocation density of 5 × 10⁶ cm⁻² or less.

The gallium nitride substrate according to an aspect 3-4 of the present invention is directed to the gallium nitride substrate according to any one of the aspects 3-1 to 3-3, in which when a normal direction of the main surface is defined as a z direction, and two directions perpendicular to the z direction and perpendicular to each other are defined as an x direction and a y direction, respectively, a fluctuation range of an x-direction component of an off-cut angle on a first line passing through a center of the main surface and extending in the x direction and a fluctuation range of a y-direction component of the off-cut angle on a second line passing through the center of the main surface and extending in the y direction are each 0.2 degrees or less within a section of a length of 40 mm.

The gallium nitride substrate according to an aspect 3-5 of the present invention is directed to the gallium nitride substrate according to any one of the aspects 3-1 to 3-4, in which one or more conditions regarding impurity concentrations are satisfied, the one or more conditions being selected from the following conditions (a) to (c):
condition (a) a Si concentration is 5 × 10¹⁶ atoms/cm³ or more;
condition (b) an O concentration is 3 × 10¹⁶ atoms/cm³ or less; and
condition (c) a H concentration is 1 × 10¹⁷ atoms/cm³ or less.

### <Fourth Aspect>

An aspect 4-1 of the present invention provides a gallium nitride substrate including a main surface inclined by 0° to 20° from the (0001) plane and having an area of 15 cm² or more, in which an absolute value of an a-axis BOW of the main surface is 1 µm or less, and an absolute value of an m-axis BOW is 1 µm or less.

The gallium nitride substrate according to an aspect 4-2 of the present invention is directed to the gallium nitride substrate according to the aspect 4-1, in which the main surface has a dislocation density of 5 × 10⁶ cm⁻² or less.

The gallium nitride substrate according to an aspect 4-3 of the present invention is directed to the gallium nitride substrate according to the aspect 4-1 or 4-2, in which when a normal direction of the main surface is defined as a z direction, and two directions perpendicular to the z direction and perpendicular to each other are defined as an x direction and a y direction, respectively, a fluctuation range of an x-direction component of an off-cut angle on a first line passing through a center of the main surface and extending in the x direction and a fluctuation range of a y - direction component of the off-cut angle on a second line passing through the center of the main surface and extending in the y direction are each 0.2 degrees or less within a section of a length of 40 mm.

The gallium nitride substrate according to an aspect 4-4 of the present invention is directed to the gallium nitride substrate according to the aspects 4-1 to 4-3, in which one or more conditions regarding impurity concentrations are satisfied, the one or more conditions being selected from the following conditions (a) to (c):
condition (a) a Si concentration is 5 × 10¹⁶ atoms/cm³ or more;
condition (b) an O concentration is 3 × 10¹⁶ atoms/cm³ or less; and
condition (c) a H concentration is 1 × 10¹⁷ atoms/cm³ or less.

### ADVANTAGEOUS EFFECTS OF INVENTION

According to one aspect of the present invention, a GaN substrate in which strains locally present in the main surface are reduced is obtained, and therefore, deterioration in yield during LD production can be reduced when the GaN substrate is used as a c-plane GaN substrate for an LD.

According to one aspect of the present invention, a GaN substrate in which pits present in the main surface are reduced is obtained, and therefore, deterioration in yield during LD production can be reduced when the GaN substrate is used as a c-plane GaN substrate for an LD.

According to one aspect of the present invention, a GaN substrate having a flat shape is obtained, and therefore, deterioration in yield during LD production can be reduced when the GaN substrate is used as a c-plane GaN substrate for an LD.

### BRIEF DESCRIPTION OF DRAWINGS

[FIG. 1] FIG. 1 is a perspective view illustrating an example of a c-plane GaN substrate according to the present embodiment.
[FIG. 2] FIG. 2 is a view illustrating that an off-cut angle of the c-plane GaN substrate can be decomposed into components in two directions perpendicular to each other.
[FIG. 3] FIG. 3 is a cross-sectional view illustrating how a facet growth region is formed.
[FIG. 4] (a) to (c) of FIG. 4 are cross-sectional views of a laminate that can be formed in a HVPE process.
[FIG. 5] FIG. 5 is a flowchart illustrating an example of a method for producing a GaN substrate according to the present embodiment.
[FIG. 6] FIG. 6 is an enlarged view of a vicinity of local strains in a crossed Nicols image obtained for a c-plane GaN substrate acquired in Example 1-1.
[FIG. 7] FIG. 7 is a schematic diagram illustrating an apparatus for performing a photoelasticity measurement.
[FIG. 8] FIG. 8 is a schematic diagram illustrating regions defining an a-axis BOW and an m-axis BOW in a GaN substrate according to an aspect of the present embodiment.

### DESCRIPTION OF EMBODIMENTS

The term "GaN crystal" in the present description means a hexagonal GaN crystal having a wurtzite crystal structure, unless otherwise specified.

In the GaN crystal, a crystal axis parallel to a [0001] axis and a [000-1] axis is called a c-axis, a crystal axis parallel to a <10-10> axis is called an m-axis, and a crystal axis parallel to a <11-20> axis is called an a-axis. A crystal plane perpendicular to the c-axis is called a c-plane, a crystal plane perpendicular to the m-axis is called an m-plane, and a crystal plane perpendicular to the a-axis is called an a-plane. In the present description, the (0001) crystal plane and the (000-1) crystal plane are collectively referred to as a c-plane.

Hereinafter, when referring to a crystal axis, a crystal plane, a crystal orientation, and the like, they mean a crystal axis, a crystal plane, a crystal orientation, and the like of a GaN crystal unless otherwise specified.

The Miller index (h k i l) of a hexagonal crystal has a relationship of h + k = -i, and therefore, it may also be represented by three digits of (h k 1). For example, when (0 0 0 4) is expressed in three digits, it is (0 0 4).

Unless otherwise specified, the dislocation referred to in the present description means a threading dislocation. In the present description, screw dislocations, mixed dislocations, and edge dislocations are collectively referred to as dislocations without distinction.

Hereinafter, embodiments of the present invention will be described with reference to the drawings as appropriate.

### <<1. GaN Substrate>>

### <First Aspect>

The GaN substrate according to a first embodiment has a main surface (first main surface) inclined by 0° to 20° from a (0001) plane and an area of 15 cm² or more, and a number density of local strains in a crossed Nicols image acquired according to a sensitive color method for the first main surface is 0.5 counts·cm⁻² or less. Here, a dislocation density of the main surface is preferably 5 × 10⁶ cm⁻² or less.

The local strain in the main surface of the GaN substrate can be checked by crossed Nicols image observation based on a sensitive color method.

In the sensitive color method, a measurement is performed using an optical system in which a white light source, a polarizer, a GaN substrate as a measurement target, a sensitive color plate (one-wavelength plate), and an analyzer are disposed in this order. The sensitive color plate is disposed such that an optical axis thereof forms an angle of 45° with a polarization axis of the polarizer, and the analyzer is disposed such that a polarization axis thereof forms an angle of 90° with the polarization axis of the polarizer. When there is no birefringence (local residual strain) in the GaN substrate as a measurement target, light having a predetermined reference wavelength unique to the sensitive color plate among linearly polarized light having each wavelength incident on the sensitive color plate cannot pass through the analyzer because a phase difference for one wavelength is accurately given by passing the light having a predetermined reference wavelength through the sensitive color plate. However, light having a wavelength other than the reference wavelength can pass through the analyzer because the given phase difference is shifted from one wavelength. As a result, the light after passing through the analyzer lacks a component having the reference wavelength, and exhibits color correlated to the reference wavelength.

When a local strain is present in the GaN substrate as a measurement target, the wavelength of light to which a phase difference of one wavelength is given by the GaN substrate and the sensitive color plate is shifted from the reference wavelength by an amount corresponding to the magnitude of birefringence. Therefore, since the light after passing through the analyzer develops a color reflecting the local strain in the GaN substrate, the local strain in the main surface of the GaN substrate can be found by observing the difference between a color of a background without the local strain and the color reflecting the local strain.

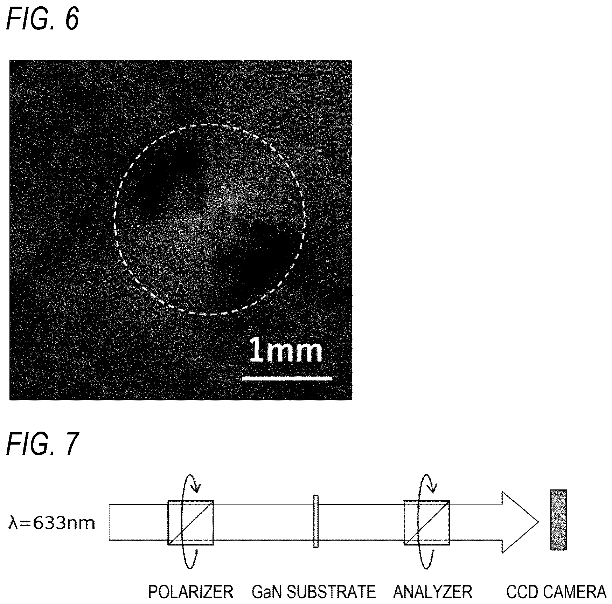

In the observed crossed Nicols image, the local strain is observed as a pattern of color variation resembling slightly cloverleaf-shaped, and therefore, the presence of the local strain can be checked by visual inspection of the crossed Nicols image. A typical local strain is observed as slightly cloverleaf-shaped having a diameter of 500 µm to 2500 µm. The number of local strains visually measured is divided by the area of the first main surface to calculate the number density of local strains. Note that FIG. 6 is an enlarged view of a vicinity of local strains in a crossed Nicols image obtained for a c-plane GaN substrate acquired in Example 1-1 to be described below. A region surrounded by a dotted line in FIG. 6 is a region where the local strains are observed. Although FIG. 6 is a black-and-white diagram, a difference in color tone from the background has actually been observed.

It has been found that when a local strain is present in the main surface in the case where a GaN substrate is used as an LD substrate, a desired end face cannot be formed when the GaN substrate is separated from the wafer in a bar shape. A shape of the end face greatly affects the LD characteristics, and therefore, the local strain leads to deterioration in the yield during LD production. In contrast, in the GaN substrate of the present embodiment, the local strain in the main surface is effectively reduced, and therefore, when the GaN substrate is used as the c-plane substrate for an LD, the deterioration in the yield during LD production can be sufficiently reduced.

From the above viewpoint, the number density of the local strains is preferably 0.4 counts·cm⁻² or less, more preferably 0.3 counts·cm⁻² or less, still more preferably 0.25 counts·cm⁻² or less, yet still more preferably 0.2 counts·cm⁻² or less, and particularly preferably 0.1 counts·cm⁻² or less. The number density of local strains is also preferably 0 count·cm⁻², which means that no local strain is observed in the main surface.

The GaN substrate according to a second embodiment has a main surface (first main surface) inclined by 0° to 20° from the (0001) plane and having an area of 15 cm² or more, and at least one 2.5 cm × 2.5 cm square lattice in which no local strain is observed can be found in a crossed Nicols image acquired under the above conditions for the first main surface. Here, a dislocation density of the main surface is preferably 5 × 10⁶ cm⁻² or less.

As described above, when the GaN substrate is used as a c-plane substrate for an LD, the local strains in the main surface of the GaN substrate can be a factor that causes the yield during LD production to deteriorate. Therefore, the wider the region where no local strain is present in the main surface, the more preferable from the viewpoint of preventing the deterioration in the yield during LD production. Therefore, in the GaN substrate according to the second embodiment, at least one 3 cm × 3 cm square lattice in which no local strain is observed can be preferably found, and at least one 4 cm × 4 cm square lattice can be more preferably found.

### <Second Aspect>

The GaN substrate according to the first embodiment has a main surface (first main surface) inclined by 0° to 20° from a (0001) plane and having an area of 15 cm² or more, and a maximum value in the main surface of a strain evaluation value calculated based on the following formula (1) by a photoelasticity measurement for the first main surface is 1 × 10⁻⁴ or less.
[Math. 7] $STRAIN EVALUATION VALUE : \left|{S}_{r}-{S}_{t}\right| = {\left[{\left({S}_{yy}-{S}_{xx}\right)}^{2}+{\left(2 {S}_{xy}\right)}^{2}\right]}^{\frac{1}{2}}$

Each term in the formula (1) is represented by the following formulae (2) and (3). $\begin{matrix}\left|{S}_{yy}-{S}_{xx}\right| = \frac{λδ}{{πdn}_{0}^{3}} \left|\frac{cos 2 ϕ}{{p}_{11} - {p}_{12}}\right| \left(2\right) \\ 2 \left|{S}_{xy}\right| = \left|\left({S}_{yy}-{S}_{xx}\right)tan 2ψ\right| \left(3\right)\end{matrix}$

Here, δ and ψ represent a phase difference which is a birefringence amount derived from a strain and a principal axis azimuth angle, respectively, λ represents a light source wavelength of a photoelasticity measurement apparatus, d represents a sample thickness, n₀ represents a strain-free refractive index with respect to the light source wavelength, and |p₁₁ - p₁₂| represents a photoelastic tensor component. Among these, λ, n₀, and |p₁₁ - p₁₂| satisfy the following conditions: $λ = 633 nm ;$ ${n}_{0} = 2.355 ;$ and $\left|{p}_{11}-{p}_{12}\right| = 0.13 .$

When the photoelasticity measurement is used, local strains present in the main surface of the GaN substrate can be quantitatively measured. The local strain amount is expressed as the magnitude of the strain evaluation value.

Hereinafter, the principle of the photoelasticity measurement will be described in detail.

When a strain due to residual stress is present in a crystal or when an external force is applied, birefringence occurs due to a photoelastic effect. The quantitative evaluation of the strain component can be performed by measuring the phase difference δ, which is the birefringence amount, and the principal axis azimuth angle ψ with respect to the strain in the crystal substrate according to the photoelastic method and using an anisotropic elastic constant of the crystal.

A gallium nitride crystal is a uniaxial crystal, and natural birefringence other than birefringence due to strain is also present therein, but natural birefringence does not appear for incident light in a normal direction of the c-plane . Therefore, in a measurement of the c-plane substrate of gallium nitride, the in-plane strain can be quantitatively evaluated without being affected by natural birefringence.

In the photoelastic method, a linear polarimeter or a circular polarimeter is mainly used. The birefringence amount can be evaluated by inserting a sample between the polarizer and the analyzer which are perpendicular to each other, transmitting light, and observing bright/dark fringe patterns such as isoclinic fringes that appear when the polarizer/analyzer orientation coincides with the primary axis direction of the birefringence amount or isochromatic fringes that appear when the phase difference of birefringence is 2πn (n is an integer). The phase difference of birefringence is also proportional to the sample thickness (transmission path length of light).

However, when the strain causing the photoelastic effect is very small or the sample thickness is small (a compound semiconductor substrate generally has a thickness of several hundred micrometers), and the phase difference generated by the strain does not satisfy 2π, the fringe pattern cannot be observed. On the other hand, the birefringence amount can be measured using a rotary analyzer method with a circular polarimeter.

The present measurement and the strain analysis are performed using a photoelastic method discussed in Non-Patent Literature 1 and Non-Patent Literature 2. In this method, the circular polarimeter is similar to a linear polarimeter, but has a structure in which a polarizer and an analyzer are synchronously rotated while accurately maintaining any relative angle, and a transmitted light intensity of a sample can be collected as a function of a polarization angle φ. By analyzing the polarization characteristics, the strain can be quantitatively evaluated in consideration of the elastic anisotropy of the crystal. Further, there is an advantage that the polarization characteristics of light used in the present measurement and the reflectance of the sample are not affected.

The measurement method will be described below.

In the case where the transmitted light intensities of the sample when the orientations of the polarizer and the analyzer are in a perpendicular state and a parallel state are defined as I_{⊥}(φ) and I_{∥} (φ), respectively, the transmitted light intensity ratio Iᵣ (φ) is represented by the following formula using a phase difference δ which is a birefringence amount derived from the strain and a principal axis azimuth angle ψ. ${I}_{r} \left(ϕ\right) = \frac{{I}_{⊥} \left(ϕ\right)}{{I}_{⊥} \left(ϕ\right) + {I}_{∥} \left(ϕ\right)} = {sin}^{2} 2 \left(ϕ-ψ\right) {sin}^{2} \left(\frac{δ}{2}\right)$

In an actual transmitted light measurement, the polarization angle φ is measured at intervals of 2π/J (J is the number of divisions) to obtain each Iᵣ(φⱼ). Here, φⱼ = 2πj/J (j = 0, 1, 2..., J - 1), and the measurement accuracy improves as the number of divisions J increases.

From the above formula, δ and ψ are obtained by converting Iᵣ(φ) into sin and cos as shown below. $\begin{matrix}δ = 2 {sin}^{- 1} \left[16\left({I}_{sin}^{2}+{I}_{cos}^{2}\right)\right] \\ ψ = \frac{1}{4} {tan}^{- 1} \frac{{I}_{sin}}{{I}_{cos}} \\ {I}_{sin} = \frac{1}{J} {\sum }_{j}^{J - 1} {I}_{r} \left(ϕ\right) sin 4 {ϕ}_{j} = - \frac{1}{4} sin 4 {ψsin}^{2} \frac{δ}{2} \\ {I}_{cos} = \frac{1}{J} {\sum }_{j}^{J - 1} {I}_{r} \left({ϕ}_{j}\right) cos 4 {ϕ}_{j} = - \frac{1}{4} cos 4 {ψsin}^{2} \frac{δ}{2}\end{matrix}$

Next, a relationship between the strain component in the crystal due to the photoelastic effect and the refractive index is represented by the following formula. ${n}_{ij}^{2} = {p}_{ijkl} {S}_{kl}$

In the above formula, nᵢⱼ represents a refractive index tensor, pᵢⱼₖₗ represents a photoelastic constant, and Sₖₗ represents a strain tensor.

However, in Non-Patent Literature 1 described above, there is a case where δ and the strain in the crystal are not simply proportional to each other due to the anisotropy of the photoelastic effect, and even when the strains have the same value, δ and ψ generated when the strain tensor components are different are different, and therefore, it is more appropriate to express δ and ψ in terms of the in-plane strain component instead of δ and ψ.

Therefore, in Non-Patent Literature 3, according to tensor analysis of a photoelastic effect generated by incident light in a normal direction of the c-plane of gallium nitride, a phase difference δ which is a birefringence amount derived from the strain and a principal axis azimuth angle ψ are converted into |S_{yy} - Sₓₓ| and 2|S_{xy}| as in the following formulae. $\begin{matrix}\left|{S}_{yy}-{S}_{xx}\right| = \frac{λδ}{πd {n}_{0}^{3}} \left|\frac{cos 2 ϕ}{{p}_{11} - {p}_{12}}\right| \\ 2 \left|{S}_{xy}\right| = \left|\left({S}_{yy}-{S}_{xx}\right)tan 2ψ\right|\end{matrix}$

|S_{yy} - Sₓₓ| represents a differential strain between the expansion and contraction along the x-axis and y-axis directions, which are the crystal axis directions, and 2|S_{xy}| represents a shear strain between the x axis and y axis. In addition, λ represents a light source wavelength of the photoelasticity measurement apparatus, d represents a sample thickness, and n₀ represents a strain-free refractive index with respect to the light source wavelength. In the experiment described in Non-Patent Literature 3, the photoelastic tensor component |p₁₁ - p₁₂| is determined to be 0.13 for a light source wavelength of 630 nm.

In the case of a substrate processed into a circular shape, the difference |Sᵣ - Sₜ| in the differential strain between the expansion and contraction in a radial direction and a tangential direction in a cylindrical coordinate system is represented by the following formula using |S_{yy} - Sₓₓ| and 2|S_{xy}|. $\left|{S}_{r}-{S}_{t}\right| = {\left[{\left({S}_{yy}-{S}_{xx}\right)}^{2}+{\left(2{S}_{xy}\right)}^{2}\right]}^{\frac{1}{2}}$

The present inventors used the above formula as the formula (1), and used the value of |Sᵣ - Sₜ| represented by this formula as the strain evaluation value. As a specific configuration or the like of the measurement apparatus used to determine the strain evaluation value, a configuration or a method to be described below can be used.

It has been found that when a local strain is present in the main surface in the case where a GaN substrate is used as an LD substrate, a desired end face cannot be formed when the GaN substrate is separated from the wafer in a bar shape. A shape of the end face greatly affects the LD characteristics, and therefore, the local strain leads to deterioration in the yield during LD production. In contrast, in the GaN substrate of the present embodiment, the local strain in the main surface is effectively reduced, and therefore, when the GaN substrate is used as the c-plane substrate for an LD, the deterioration in the yield during LD production can be sufficiently reduced.

From the above viewpoint, the maximum value in the main surface of the strain evaluation value in the main surface of the GaN substrate according to the first embodiment is preferably 9 × 10⁻⁵ or less, more preferably less than 6 × 10⁻⁵, and still more preferably less than 5 × 10⁻⁵.

A GaN substrate according to the second embodiment has a main surface (first main surface) inclined by 0° to 20° from a (0001) plane and having an area of 15 cm² or more, and an area (S1) where a strain evaluation value calculated based on the formula (1) by the photoelasticity measurement for the first main surface is 6 × 10⁻⁵ or more is 0.10% or less of an area of the entire main surface.

Here, the above strain evaluation value is the same as the strain evaluation value in the first embodiment described above.

As described above, when the GaN substrate is used as a c-plane substrate for an LD, the local strains in the main surface of the GaN substrate can be a factor that causes the yield during LD production to deteriorate. Therefore, the smaller the area of the region where the local strain is large in the main surface, the more preferable from the viewpoint of preventing the deterioration in the yield during LD production. Therefore, in the GaN substrate according to the second embodiment, the area (S1) where the strain evaluation value measured by the photoelasticity measurement is 6 × 10⁻⁵ or more is preferably less than 0.05% of the area of the entire main surface, and particularly preferably 0% of the area of the entire main surface.

A GaN substrate according to a third embodiment has a main surface (first main surface) inclined by 0° to 20° from a (0001) plane and having an area of 15 cm² or more, and a ratio (S1/S2) of an area (S1) where a strain evaluation value is 6 × 10⁻⁵ or more to an area (S2) where a strain evaluation value is 5 × 10⁻⁵ or more calculated based on the following formula (1) by the photoelasticity measurement for the first main surface is 50% or less.

Here, the above strain evaluation value is the same as the strain evaluation value in the first embodiment described above.

As described above, when the GaN substrate is used as a c-plane substrate for an LD, the local strains in the main surface of the GaN substrate can be a factor that causes the yield during LD production to deteriorate. As a result of studies, the present inventors have found that the higher the ratio (S1/S2) of the area (S1) where a strain evaluation value is 6 × 10⁻⁵ or more to the area (S2) where a strain evaluation value is 5 × 10⁻⁵ or more, the more strongly the adverse effect on the yield during LD production is concerned. From this viewpoint, in the GaN substrate according to the third embodiment, the ratio (S1/S2) of the area (S1) where a strain evaluation value is 6 × 10⁻⁵ or more to the area (S2) where a strain evaluation value is 5 × 10⁻⁵ or more on the main surface is preferably 30% or less, more preferably 20% or less, still more preferably 10% or less, particularly preferably 5% or less, and most preferably 0%.

### <Third Aspect>

The GaN substrate according to the first embodiment has a main surface (first main surface) inclined by 0° to 20° from the (0001) plane and having an area of 15 cm² or more, and a number density of pits in the first main surface is less than 0.3 counts·cm⁻².

The pits in the main surface of the GaN substrate can be checked by visual observation with the naked eye or optical microscope observation.

It has been found that when a pit is present in the main surface in the case where a GaN substrate is used as an LD substrate, a desired end face cannot be formed when the GaN substrate is separated from the wafer in a bar shape. The shape of the end face greatly affects the LD characteristics, and therefore, the pit leads to deterioration in the yield during LD production. In contrast, in the GaN substrate of the present embodiment, the pits in the main surface are effectively reduced, and therefore, when the GaN substrate is used as the c-plane substrate for an LD, the deterioration in the yield during LD production can be sufficiently reduced.

From the above viewpoint, the number density of the pits is preferably 0.25 counts·cm⁻² or less, more preferably 0.2 counts·cm⁻² or less, still more preferably 0.15 counts·cm⁻² or less, yet still more preferably 0.1 counts· cm⁻² or less, and particularly preferably 0.05 counts·cm⁻² or less. The number density of pits is preferably 0 count· cm⁻², which means that no pit is observed in the main surface.

The GaN substrate according to the second embodiment has a main surface (first main surface) inclined by 0° to 20° from the (0001) plane and having an area of 15 cm² or more, and at least one 2.5 cm × 2.5 cm square lattice in which no pit is observed can be found on the first main surface.

As described above, when the GaN substrate is used as a c-plane substrate for an LD, the pits in the main surface of the GaN substrate may cause deterioration in the yield during LD production. Therefore, the wider the region where no pit is present in the main surface, the more preferable from the viewpoint of preventing the deterioration in the yield during LD production. Therefore, in the GaN substrate according to the second embodiment, at least one 3 cm × 3 cm square lattice in which no pit is observed can be preferably found, and at least one 4 cm × 4 cm square lattice can be more preferably found.

### <Fourth Aspect>

The GaN substrate according to the first embodiment has a main surface (first main surface) inclined by 0° to 20° from the (0001) plane and having an area of 15 cm² or more, and an absolute value of an a-axis BOW of the first main surface is 1 µm or less, and an absolute value of an m-axis BOW is 1 µm or less.

The flatness of a shape of the GaN substrate can be represented using a height of a substrate center relative to a reference plane (BOW) as an index. The a-axis BOW and the m-axis BOW are defined as follows.

A line having a width of 1 mm parallel to the a-axis and the m-axis passing through a substrate center point is set as a target region, and the height of a wafer center from a least squares plane in this region is calculated. The a-axis BOW and the m-axis BOW are obtained by assigning a plus sign to the numerical value in a case where the numerical value is above (convex upward) the least squares plane and assigning a minus sign to the numerical value in a case where the numerical value is below (convex downward) the least squares plane.

According to the definition of Semiconductor Equipment and Materials International (SEMI), BOW employs a three-point reference plane, but it is less likely to select appropriate three points in the target region on the a-axis BOW and the m-axis BOW. Therefore, the least squares plane is employed.

When the GaN substrate has a warpage of a certain size or more in the case where a GaN substrate is used as an LD substrate, heat transfer from a susceptor of an LD production apparatus becomes uneven, which leads to deterioration in the yield during LD production. In contrast, the GaN substrate of the present embodiment is a substrate in which warpage of the main surface is reduced and flatness is excellent, and therefore, deterioration in the yield during LD production can be sufficiently reduced when the GaN substrate is used as a c-plane substrate for an LD.

From the above viewpoint, the absolute value of the a-axis BOW of the first main surface is preferably as small as possible, and specifically, is preferably 0.8 µm or less, more preferably 0.6 µm or less, and still more preferably 0.5 µm or less.

From the same viewpoint, the absolute value of the m-axis BOW of the first main surface is preferably as small as possible, and specifically, is preferably 0.8 µm or less, more preferably 0.6 µm or less, and still more preferably 0.5 µm or less.

From the same viewpoint, in the GaN substrate, the absolute value of the a-axis BOW and the absolute value of the m-axis BOW of the first main surface are preferably as small as possible at the same time, and specifically, both are preferably 0.8 µm or less, more preferably 0.6 µm or less, and still more preferably 0.5 µm or less.

In the main surface of the GaN substrate, a smaller dislocation density is preferable because the crystal quality is excellent.

The dislocation density in the first main surface of the GaN substrate is preferably 5 × 10⁶ cm⁻² or less, more preferably 2 × 10⁶ cm⁻² or less, still more preferably 1 × 10⁶ cm⁻² or less, yet still more preferably 8 × 10⁵ cm⁻² or less, particularly preferably 6 × 10⁵ cm⁻² or less, and most preferably 5 × 10⁵ cm⁻² or less. The dislocation density is generally 1 × 10⁴ cm⁻² or more.

Since dislocations appear as dark spots in a cathode luminescence (CL) image of GaN crystals, the dislocation density can be measured by CL image observation. When the first main surface has Ga polarity, the density of etch pits in a first main surface 101 after etching the substrate with sulfuric acid having a concentration of 89% heated to 270°C for 1 hour may be regarded as the dislocation density.

When the dislocation density in the first main surface 101 of a substrate 100 is evaluated, a rectangular area having an area of 180 µm × 180 µm (32400 µm²) or more is preferably observed at each measurement point. When the observation area is 180 µm × 180 µm or more, the maximum value of the dislocation density in the first main surface 101 does not exceed four times the minimum value, and is generally three times or less, and may be two times or less.

When the dislocation density in the first main surface is evaluated, a region where the distance from an outer periphery of the substrate is less than 5 mm may be excluded as an exceptional region.

Hereinafter, GaN substrates according to the first embodiment and the second embodiment in the first aspect, the first embodiment to the third embodiment in the second aspect, the first embodiment and the second embodiment in the third aspect, and the first embodiment in the fourth aspect (hereinafter, may be collectively referred to as the present embodiment) will be further described.

The inclination of the first main surface from the (0001) plane is 0 degree to 20 degrees, but may be 0.2 degrees or more, and may be 10 degrees or less, less than 5 degrees, less than 2.5 degrees, less than 1.5 degrees, less than 1 degree, or less than 0.5 degrees.

The area of the first main surface may be 15 cm² or more, may be 18 cm² or more, and may be 200 cm² or less.

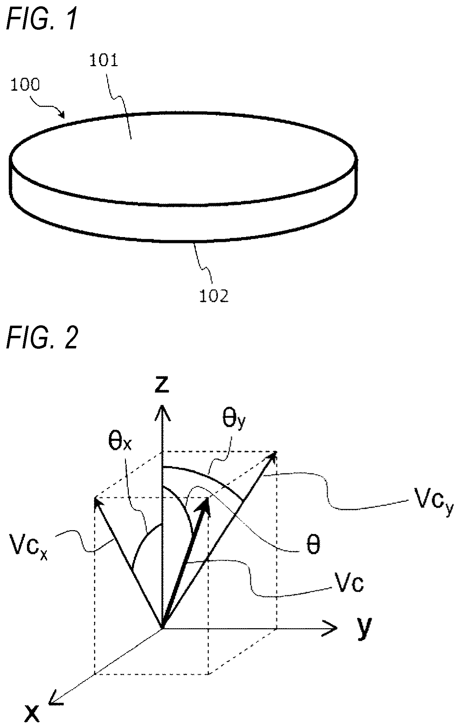

FIG. 1 illustrates an example of the GaN substrate according to the present embodiment.

The substrate 100 illustrated in FIG. 1 is a free-standing GaN wafer and has two main surfaces (large-area surfaces) facing each other in opposite directions, that is, the first main surface 101 and a second main surface 102.

The first main surface 101 and the second main surface 102 are preferably parallel to each other.

The first main surface 101 is a main surface used for epitaxial growth of a nitride semiconductor when producing a nitride semiconductor device or the like, that is, a "front surface". The second main surface 102 is a "back surface".

In the present description, the first main surface 101 has Ga polarity, and the other second main surface 102 has N polarity.

The inclination of the second main surface 102 relative to the (000-1) crystal plane is preferably 0 degree or more and 20 degrees or less. The inclination may be 0.2 degrees or more, and may be 10 degrees or less, less than 5 degrees, less than 2.5 degrees, less than 1.5 degrees, less than 1 degree, or less than 0.5 degrees.

The diameter of the substrate 100 is not particularly limited as long as the area of the first main surface 101 is 15 cm² or more. The diameter of the substrate 100 is generally 45 mm or more, may be 95 mm or more, or 145 mm or more, and is typically 50 mm to 55 mm (about 2 inches), 100 mm to 105 mm (about 4 inches), 150 mm to 155 mm (about 6 inches), or the like.

The thickness of the substrate 100 is designed such that the substrate 100 can be free-standing and handled.

When the diameter of the substrate 100 is about 2 inches, the thickness thereof is preferably 250 µm or more, more preferably 300 µm or more, and is preferably 500 µm or less, more preferably 450 µm or less.

When the diameter of the substrate 100 is about 4 inches, the thickness thereof is preferably 400 µm or more, more preferably 500 µm or more, and is preferably 800 µm or less, more preferably 650 µm or less. In the above <Fourth Aspect>, when the diameter of the substrate 100 is about 4 inches, the thickness thereof is preferably 350 µm or more, more preferably 400 µm or more, and is preferably 800 µm or less, more preferably 650 µm or less.

When the diameter of the substrate 100 is about 6 inches, the thickness thereof is preferably 500 µm or more, more preferably 600 µm or more, and is preferably 850 µm or less, more preferably 750 µm or less. In the above <Fourth Aspect>, when the diameter of the substrate 100 is about 6 inches, the thickness thereof is preferably 400 µm or more, more preferably 500 µm or more, and is preferably 850 µm or less, more preferably 750 µm or less.

An off-cut angle of the substrate 100 can be decomposed into components in two directions perpendicular to each other in the first main surface 101, that is, an x-direction component and a y-direction component. This will be described below with reference to FIG. 2.

When a normal direction of the first main surface 101 is a z direction and a vector parallel to the c-axis is a vector Vc, the off-cut angle of the wafer 20 is equal to an inclination θ of the vector Vc from the z direction. The vector Vc can be decomposed into a vector Vcₓ as an x-direction component and a vector Vc_{y} as a y-direction component. An orthogonal projection of the vector Vc on the xz plane is a vector Vcₓ, and an orthogonal projection of the vector Vc on the yz plane is a vector Vc_{y}.

When the vector Vc is decomposed in this manner, the inclination of the vector Vcₓ from the z direction is the x-direction component θₓ of the off-cut angle θ, and the inclination of the vector Vc_{y} from the z direction is the y-direction component θ_{y} of the off-cut angle θ.

In the substrate 100, a fluctuation range of the x-direction component of the off-cut angle on a first line passing through a center of the first main surface 101 and extending in the x direction and a fluctuation range of the y-direction component of the off-cut angle on a second line passing through the center of the first main surface 101 and extending in the y direction are each preferably 0.2 degrees or less in a section having a length of 40 mm. The x direction may be parallel to one of the a-planes, and the y direction is parallel to one of the m-planes.

The fluctuation range here is a difference between the maximum value and the minimum value of the off-cut angle, and the fluctuation range being 0.2 degrees or less means that the fluctuation from a median value of the off-cut angle is within ±0.1 degrees.

The fluctuation range of the x-direction component of the off-cut angle on the first line and the fluctuation range of the y-direction component of the off-cut angle on the second line are preferably as small as possible. Each of these fluctuation ranges may be 0.16 degrees or less, further 0.14 degrees or less, further 0.12 degrees or less, further 0.10 degrees or less, further 0.08 degrees or less, further 0.06 degrees or less, and further 0.04 degrees or less in the section having a length of 40 mm. In the above <Fourth Aspect>, the above fluctuation range is preferably 0.2 degrees or less, and may be 0.1 degrees or less, further 0.08 degrees or less, further 0.06 degrees or less, and further 0.04 degrees or less in the section having a length of 40 mm.

When the fluctuation range of the off-cut angle is evaluated, an area where the distance from the outer periphery of the substrate is less than 5 mm may be excluded.

The first main surface 101, which is the front surface of the substrate 100, is generally mirror-finished, and the root mean square (RMS) roughness measured by an atomic force microscope (AFM) is preferably less than 2 nm in a measurement range of 2 µm × 2 µm, and may be less than 1 nm or less than 0.5 nm.

The second main surface 102, which is the back surface, may be mirror-finished or may be matte finished.

The edge of the substrate 100 may be chamfered.

The substrate 100 may be provided with various markings as necessary, such as orientation flats or notches for indicating an orientation of a crystal, and an index flat for facilitating the identification of a front surface and a back surface.

The main surface of the substrate 100 is circular, and the main surface of the substrate 100 is not limited to a circular shape in the above <First Aspect> to <Third Aspect>, and may be changed to a square, a rectangle, a hexagon, an octagon, or any other shape.

The substrate 100 can be a GaN crystal grown by HVPE.

GaN grown in a normal HVPE apparatus equipped with a quartz reactor can satisfy one or more conditions selected from the following conditions (a) to (c) for an impurity concentration:
condition (a) a Si concentration is 5 × 10¹⁶ atoms/cm³ or more;
condition (b) an O concentration is 3 × 10¹⁶ atoms/cm³ or less, and
condition (c) a H concentration is 1 × 10¹⁷ atoms/cm³ or less.

The substrate 100 may satisfy two or more of the conditions (a) to (c). In some cases, both the above conditions (a) and (b), both the above conditions (b) and (c), or both the above conditions (a) and (c) can be satisfied. In some cases, the substrate 100 may satisfy all of the above conditions (a) to (c).

In the above <First Aspect> to <Third Aspect>, the substrate 100 may be made of un-intentionally doped GaN (UID-GaN). UID-GaN generally exhibits n-type conductivity by unintentional donor impurity doping.

In UID-GaN, the carrier concentration can be increased to about 5 × 10¹⁷ atoms/cm³, and the room temperature resistivity can be decreased to about 0.04 Ω•cm. This is because the Si concentration of UID-GaN can be increased to about 5 × 10¹⁷ atoms/cm³, and the O concentration can be increased to about 2 × 10¹⁷ atoms/cm³.

In the above <First Aspect> to <Third Aspect>, for example, the room temperature resistivity of the substrate 100 can be reduced by intentional doping, and the above room temperature resistivity is less than 0.03 Ω•cm, further less than 0.02 Ω•cm, still further less than 0.015 Ω•cm, and even further less than 0.010 Ω•cm. In order to sufficiently reduce the resistivity, the carrier concentration of the substrate 100 at room temperature is preferably 1 × 10¹⁸ atoms/cm³ or more, and more preferably 2 × 10¹⁸ atoms/cm³ or more. The carrier concentration may be 3 × 10¹⁸ atoms/cm³ or more, and further 4 × 10¹⁸ atoms/cm³ or more. From the viewpoint of electrical characteristics, there is no particular upper limit to the carrier concentration, but in order not to cause the productivity of the substrate 100 to deteriorate, the carrier concentration is preferably set to 1 × 10¹⁹ atoms/cm³ or less, and may be set to 8 × 10¹⁸ atoms/cm³ or less, and further to 5 × 10¹⁸ atoms/cm³ or less. This is because strong doping increases the frequency of abnormal growth of the GaN crystal.

In the above <First Aspect> to <Third Aspect>, the dopant used for reducing the resistivity of the substrate 100 is preferably a donor impurity. This is because donor impurities generally exhibit a higher activation rate than acceptor impurities. The activation rate is a ratio of a carrier concentration to a dopant concentration of doped GaN.

The elements acting as donors in GaN crystal include group 14 elements such as Si (silicon) and Ge (germanium) and group 16 elements such as O (oxygen) and S (sulfur), and Si and Ge are preferred as intentional dopants. The GaN crystal intentionally doped with Ge may contain Si as an unintentional dopant at the same concentration as Ge.

In the above <First Aspect> to <Third Aspect>, when the dislocation density in the first main surface 101 of the substrate 100 is evaluated, a rectangular area having an area of 180 µm × 180 µm (32400 µm²) or more is preferably observed at each measurement point. When the observation area is 180 µm × 180 µm or more, the maximum value of the dislocation density in the first main surface 101 does not exceed four times the minimum value, and is generally three times or less, and may be two times or less.

In the above <First Aspect> to <Third Aspect>, the dislocation density in the first main surface 101 of the substrate 100 is preferably 5 × 10⁶ cm⁻² or less, more preferably 1 × 10⁶ cm⁻² or less, still more preferably 7 × 10⁵ cm⁻² or less, and yet still more preferably 5 × 10⁵ cm⁻² or less. The dislocation density is generally 1 × 10⁵ cm⁻² or more.

Since dislocations appear as dark spots in a cathode luminescence (CL) image of GaN crystals, the dislocation density can be measured by CL image observation. When the first main surface 101 has Ga polarity, the density of etch pits in the first main surface 101 after etching the substrate 100 with sulfuric acid having a concentration of 89% heated to 270 °C for 1 hour may be regarded as the dislocation density.

When the dislocation density in the first main surface 101 is evaluated, a region where the distance from the outer periphery of the substrate is less than 5 mm, and a facet growth region may be excluded as exceptional regions.

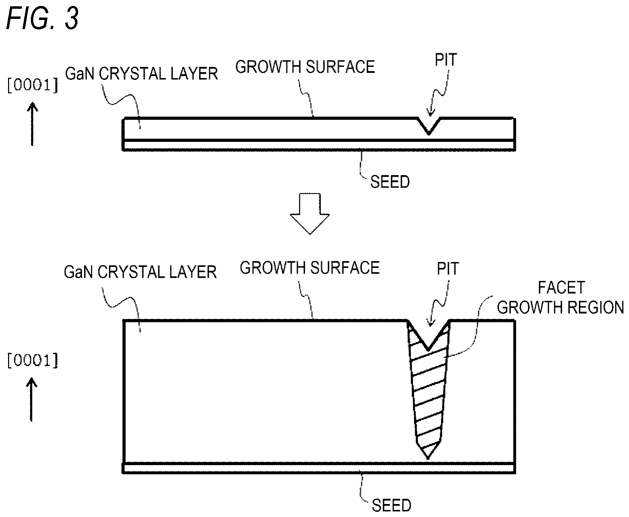

In addition, regarding the above <First Aspect> to <Third Aspect>, FIG. 3 is a cross-sectional view illustrating a state in which a c-axis oriented GaN crystal layer grows in a [0001] direction on a seed, and the facet growth region is hatched. As can be seen from FIG. 3, when pits that do not disappear from the growth surface even if the GaN crystal layer grows are generated on the surface of the GaN crystal layer grown in the [0001] direction, a region through which the pits pass is the facet growth region.

The facet growth region often tends to increase in diameter with growth, and may have a core having a locally increased defect density therein.

In the first main surface 101 of the substrate 100, the diameter of one facet growth region is generally in a range of 50 µm to 1000 µm. The number density of facet growth regions in the first main surface 101 is at most 1 per 2 cm², and is preferably 1 or less per 4 cm². A total area of the facet growth regions in the first main surface 101 is 1.5% or less, preferably 0.75% or less, of the area of the first main surface.

The GaN crystal forming the facet growth region and the GaN crystal forming the region other than the facet growth region have different surface orientations during the growth, and the oxygen concentration and the carrier concentration of the facet growth region are generally higher than those in the region other than the facet growth region.

In the above <First Aspect>, the GaN substrate according to the first embodiment may be one in which at least one 2.5 cm × 2.5 cm square lattice in which no local strain is observed can be found in a crossed Nicols image acquired under the above conditions on the first main surface.

In the above <First Aspect>, from the same viewpoint as in the case of the GaN substrate according to the second embodiment, in the GaN substrate according to the first embodiment, it is more preferable that at least one 3 cm × 3 cm square lattice in which no local strain is observed can be found, and it is still more preferable that at least one 4 cm × 4 cm square lattice in which no local strain is observed can be found in the crossed Nicols image.

In the above <Second Aspect>, in the GaN substrate according to the above first embodiment, the area (S1) in which the strain evaluation value calculated based on the above-described formula (1) by the photoelasticity measurement for the main surface is 6 × 10⁻⁵ or more may be 0.10% or less, less than 0.05%, or 0% of the area of the entire main surface.

In the above <Second Aspect>, in the GaN substrate according to the above first embodiment, the ratio (S1/S2) of the area (S1) in which a strain evaluation value is 6 × 10⁻⁵ or more to the area (S2) in which a strain evaluation value calculated based on the formula (1) by the photoelasticity measurement for the main surface is 5 × 10⁻⁵ or more may be 50% or less, 30% or less, 20% or less, 10% or less, or 5% or less.

In the above <Second Aspect>, in the GaN substrate according to the above second embodiment, the ratio (S1/S2) of the area (S1) in which a strain evaluation value is 6 × 10⁻⁵ or more to the area (S2) in which a strain evaluation value calculated based on the formula (1) by the photoelasticity measurement for the main surface is 5 × 10⁻⁵ or more may be 50% or less, 30% or less, 20% or less, 10% or less, or 5% or less.

In the above <Third Aspect>, the GaN substrate according to the above first embodiment may be one in which at least one 2.5 cm × 2.5 cm square lattice in which no pit is observed can be found on the first main surface.

In the above <Third Aspect>, from the same viewpoint as in the case of the GaN substrate according to the above second embodiment, in the GaN substrate according to the first embodiment, it is more preferable that at least one 3 cm × 3 cm square lattice in which no pit is observed can be found on the main surface, and it is still more preferable that at least one 4 cm × 4 cm square lattice in which no pit is observed can be found.

### 2. Method for Producing GaN substrate

An example of a method for producing the GaN substrate according to the present embodiment will be described below.

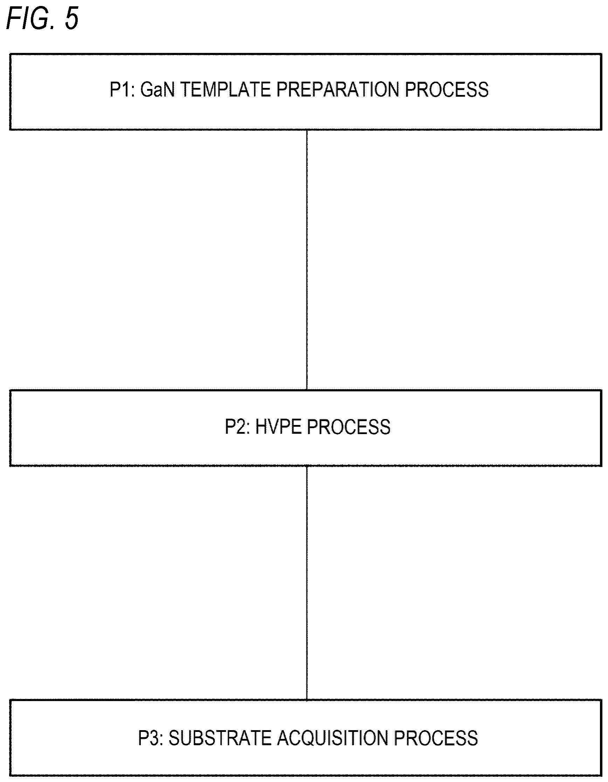

In one production method, as illustrated in the flowchart of FIG. 5, a GaN template preparation process P1 of preparing a GaN template and an HVPE process P2 of growing a GaN crystal by HVPE on the GaN template prepared in the GaN template preparation process P1 are performed in this order. Thereafter, the processing proceeds to a substrate acquisition process P3 of obtaining a GaN substrate by slicing the grown GaN crystal.

In the above <First Aspect> to <Third Aspect>, the HVPE process P2 includes growing a pitted layer and then growing a planarized layer by changing the growth conditions.

Each process will be described in detail below.

### 2.1. GaN Template Preparation Process

The GaN template prepared in the GaN template preparation process P1 serves as a seed when a GaN crystal layer is grown in the subsequent HVPE process P2.

In the GaN template preparation process P1, a GaN crystal thin film is epitaxially grown on a c-plane hetero substrate, and a separation layer is formed on the GaN crystal thin film to obtain a GaN template with the separation layer.

The hetero substrate is a single crystal substrate made of a compound having a composition different from that of GaN, and is, for example, a sapphire substrate.

A c-axis oriented GaN crystal thin film is epitaxially grown on a c-plane hetero substrate by a metal organic chemical vapor deposition (MOCVD) method to obtain a GaN template. The thickness of the GaN crystal thin film is, for example, 1 µm to 5 µm. The dislocation density of the surface of the GaN crystal thin film is preferably 1 × 10⁷ cm⁻² to 1 × 10¹⁰ cm⁻².

A SiNx film is deposited on a surface of the GaN crystal thin film of the obtained GaN template. Examples of the deposition method that can be used include a plasma CVD method and a sputtering method. The thickness of the SiNx film can be, for example, 100 Å to 10000 Å.

The deposited SiNx film is patterned by photolithography and dry etching to form a separation film. Examples of a preferable mask pattern include a triangular lattice type net pattern. The aperture ratio can be in a range of 15% to 75%. Accordingly, a GaN template with a pattern mask is obtained.

### 2.2. HVPE Process

In the HVPE process P2, a GaN crystal is grown by the HVPE method on the surface of a GaN template prepared in the GaN template preparation process P1.

In the HVPE process P2, an initial layer, an intermediate layer, a pitted layer, a planarized layer, and a main growth layer are grown in this order.

An operation of growing the pitted layer and then growing the planarized layer by changing the growth conditions is performed one or more times. This operation can be repeated two or more times.

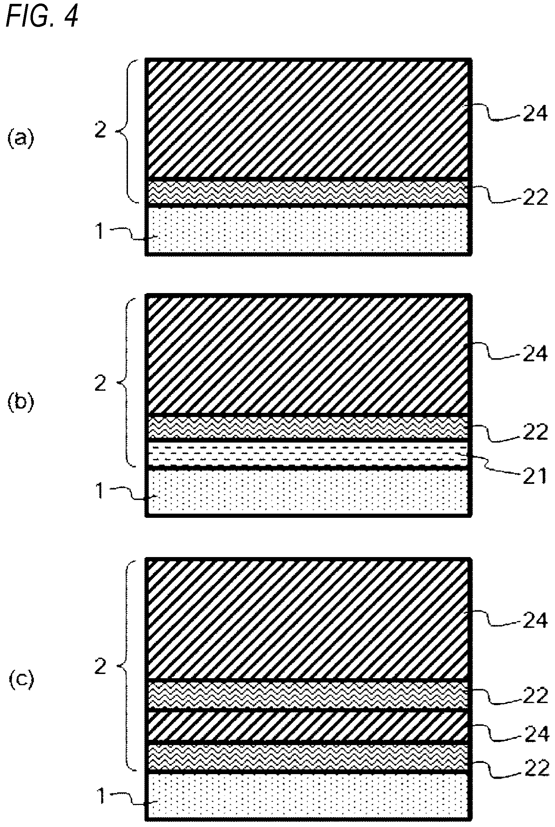

(a) to (c) of FIG. 4 are cross-sectional views illustrating laminates that can be formed in the HVPE process P2 in the above <First Aspect> to <Third Aspect>, respectively. Each laminate includes a single crystal GaN (0001) substrate 1 and a GaN crystal 2 grown on a (0001) surface thereof.

In the example of (a) of FIG. 4, the GaN crystal 2 includes a pitted layer 22 grown directly on the single crystal GaN (0001) substrate 1 and a planarized layer 24 laminated on the pitted layer 22.

In the example of (b) of FIG. 4, the GaN crystal 2 includes a base layer 21 grown flat directly on the single crystal GaN (0001) substrate 1, the pitted layer 22 laminated on the base layer 21, and the planarized layer 24 laminated on the pitted layer 22.

In the example of (c) of FIG. 4, an operation of growing the pitted layer 22 and growing the planarized layer 24 thereon is repeated twice to form the GaN crystal 2.

The initial layer is grown on a surface of the GaN template by HVPE. The initial layer is formed for the purpose of separating the HVPE growth layer from the GaN template without generating defects such as cracks. The growth conditions are set such that the growth temperature is 900°C to 980°C, the V/III ratio is 1.5 to 8.0, and the F value of the carrier gas is 0.50 to 1.00. Here, the F value of the carrier gas is a molar ratio of H₂ (hydrogen gas) in the carrier gas introduced into a reactor.

The intermediate layer is grown on the initial layer. The intermediate layer is formed for the purpose of filling local pits unintentionally formed in the initial layer and planarizing the surface.

The present inventors have conducted repeated studies and found that the number of local strains and the number of pits in the main surface of the GaN crystal to be finally obtained can be effectively reduced by setting the F value of the carrier gas in a specific range as the growth condition for growing the intermediate layer in the above

### <First Aspect> to <Third Aspect>.

As the growth conditions for the intermediate layer, the growth temperature is set to 1000°C to 1100°C, and the V/III ratio is set to 3 to 10 in the above <First Aspect>, <Second Aspect>, and <Fourth Aspect>. Here, it is essential to set the F value of the carrier gas to 0.05 or more. When the F value is less than 0.05, the number of local strains in the main surface of the GaN crystal to be finally obtained increases, and when the GaN substrate is used as a c-plane substrate for an LD, there is a concern that the yield during LD production may deteriorate. It is presumed that this is because the etching effect of the H₂ gas is lost, and a local abnormal growth portion that cannot be removed during the growth generates a defect such as a dislocation, and causes strains. From the viewpoint that the crystal can be grown more stably, the F value is preferably 0.5 or less.

As the growth conditions for the intermediate layer, the growth temperature is set to 1000°C to 1100°C, and the V/III ratio is set to 3 to 10 in the above <Third Aspect>. Here, it is essential to set the F value to 0.05 or more. The lower the F value is, the more easily local pits formed unintentionally in the initial layer are filled, but when the F value is less than 0.05, dislocations tend to increase during crystal growth. The increase in dislocations induces an increase in residual stress inside the crystal, and eventually minute cracks occur during crystal growth. When the growth is continued on the crack, new pits are generated, so that the number of pits increases. The impurity concentration is different between the pit portion and the flat growth portion, and therefore, when the GaN substrate is used as a c-plane substrate for an LD, there is a concern that the yield during LD production deteriorates. On the other hand, it is presumed that when the F value is 0.05 or more, an increase in dislocations can be prevented when local pits unintentionally formed in the initial layer are filled, and thus new pits are less likely to occur. From the viewpoint that the crystal can be grown more stably, the F value is preferably 0.5 or less.

The pitted layer is grown on the intermediate layer. The pitted layer is a layer in which facet surfaces appear on the growth surface and numerous pits are formed.

During the growth of the pitted layer, the dislocations gather toward the pits, and a propagation direction of the dislocations is bent when the pits are combined, so that the probability of occurrence of pair annihilation of the dislocations increases. Therefore, the dislocation density of the GaN crystal is lower in the planarized layer laminated on the pitted layer than on the lower side of the pitted layer.

The thickness of the pitted layer is generally 10 µm or more, preferably 30 µm or more, and more preferably 50 µm or more. Surprisingly, the formation of the pitted layer having only a thickness of 100 µm or less causes a sufficiently effective reduction in the dislocation density.

The pitted GaN layer can be grown by sufficiently lowering the growth temperature within a range in which single-crystal growth is not difficult, and a selective area growth (SAG) technique is not required.

The growth conditions for the pitted layer are set such that the growth temperature is 900°C to 980°C, the V/III ratio is 1.5 to 8.0, and the F value of the carrier gas is 0.50 to 1.00.

The planarized layer is a layer grown subsequent to each pitted layer. In the planarized layer, the pits formed in the pitted layer are filled and substantially eliminated to obtain a flat crystal plane.

In order to grow the planarized layer on the pitted layer, the growth conditions may be changed. The growth temperature of the planarized layer is preferably 1000°C or higher. If necessary, in order to accelerate the planarization of the surface, either one or both of the V/III ratio and the F value of the carrier gas when the planarized layer is grown may be set to be lower than those when the pitted layer is grown.

In the above <First Aspect>, <Second Aspect>, and <Fourth Aspect>, the planarized layer is grown so that the pits on the surface substantially disappear. The state in which the pits substantially disappear refers to a state in which the pit density of a surface of the planarized layer excluding a vicinity of the outer periphery is 1 pit/cm² or less. The reason for excluding the vicinity of the outer periphery is that pits tend to occur in the vicinity of the outer periphery regardless of growth conditions.

In the above <First Aspect> and <Second Aspect>, the pit density of the surface of the planarized layer is preferably 0.5 pits/cm² or less, more preferably 0.1 pits/cm² or less, and most preferably 0 pit/cm².

The pits may substantially disappear from the surface of the planarized layer during the growth of the planarized layer.

Even after the planarized layer is grown, the thickness of the underlying pitted layer can be examined by observing a cross section perpendicular to the c-plane of the GaN crystal with a fluorescence microscope. The pitted layer and the planarized layer are likely to have different concentrations and/or types of impurities incorporated during growth, and thus have clearly different color tones in fluorescence microscope images and can be easily identified. In the fluorescence microscope image, the pitted layer appears darker than the planarized layer.

Oxygen is an impurity having a particularly different concentration between the pitted layer and the planarized layer, and the pitted layer has a higher oxygen concentration than the planarized layer.

As described above, in the HVPE process P2, the operation of growing the pitted layer, and then growing the planarized layer by changing the growth conditions is performed one or more times. This operation is preferably repeated two or more times. When the operation of alternately growing the pitted layer and the planarized layer is repeated two or more times in this manner, the effect of reducing dislocations due to the concentration of dislocations in the pits is further exhibited, and the dislocation density of the obtained GaN crystal can be effectively reduced.

As a result of studies, the present inventors have found that, as described above, when alternately growing the pitted layer and the planarized layer, local strains and pits in the main surface of the finally obtained GaN crystal can be effectively reduced by continuing the crystal growth while gradually changing the growth conditions without stopping the supply of the raw gas when shifting from the growth conditions for the pitted layer to the growth conditions for the planarized layer.

Specifically, when the crystal growth condition is changed to the growth condition of the planarized layer after the GaN crystal layer is grown as the pitted layer, the growth conditions such as the growth temperature and the V/III ratio are gradually changed while continuing the crystal growth by keeping the supply of the raw gas without stopping the supply of the raw gas. It is presumed that, when the crystal is continuously grown from the pitted layer to the planarized layer as described above, the occurrence of local abnormal growth can be prevented, and local strains and pits generated in the growth process of the GaN crystal can be reduced. As a result, the crystal quality of the obtained GaN substrate is also improved.

In the HVPE process P2, the main growth layer is finally grown on the planarized layer. The thickness of the main growth layer is generally 1 mm or more, preferably 2 mm or more, more preferably 4 mm or more, and still more preferably 8 mm or more.

The growth conditions for the main growth layer may be the same all the time, or may be changed during the growth.

In the main growth layer, the oxygen concentration is generally 2 × 10¹⁶ atoms/cm³ or less in the part grown after the pits substantially disappear from the surface.

The main growth layer can be doped with a donor impurity such as Si (silicon) or Ge (germanium), or can be doped with an impurity such as Fe (iron), Mn (manganese), Cr (chromium), or C (carbon) having an effect of making GaN semi-insulating through compensation for the donor impurity.

The doping of the main growth layer may be started after the pits on the surface substantially disappear.

In the above <First Aspect> to <Third Aspect>, as the HVPE apparatus used in the HVPE process P2, apparatuses having various common configurations can be used.

The present inventors have found that, in the process of growing a GaN crystal using the HVPE method, immediately after the start of the growth, foreign matter coming from an inner wall portion of a reactor tube constituting the HVPE apparatus and the like is mixed in and adhere to a surface of a seed, and the foreign matter can become one of starting points that cause local strains and pits in the growth surface in the crystal growth process. Such foreign matter is highly likely to be transported to the seed surface by a fluid such as a carrier gas immediately after the start of growth.

Therefore, the present inventors have conceived that local strains and pits in the main surface of the obtained GaN crystal can be further reduced by physically shielding a space immediately above the seed until just before growth begins and disposing a cover for preventing adhesion of foreign matter. For the reasons described above, it is preferable that the HVPE apparatus used in the HVPE process P2 is provided with a cover for preventing foreign matter from adhering onto the seed. For example, when the reactor tube constituting the HVPE apparatus is a vertical reactor tube, it is expected that foreign matter often falls from the upper portion of the seed and adheres to the seed surface. Therefore, in the case of a vertical reactor tube, it is effective to dispose a foreign matter adhesion preventing cover on the seed.

In the above <Fourth Aspect>, as the HVPE apparatus used in the HVPE process P2, apparatuses having various common configurations can be used.

It is preferable that the HVPE apparatus used in the HVPE process P2 is provided with a cover for preventing foreign matter from adhering onto the seed. The adhesion of foreign matter onto the seed can be a starting point of a defect in subsequent crystal growth. For example, when the reactor tube constituting the HVPE apparatus is a vertical reactor tube, it is expected that foreign matter often falls from the upper portion of the seed and adheres to the seed surface. Therefore, in the case of a vertical reactor tube, it is effective to dispose a foreign matter adhesion preventing cover on the seed.

### 2.3. Substrate Acquisition Process

In the substrate acquisition process P3, a c-plane GaN substrate having a preferable quality can be produced by slicing the main growth layer obtained in the HVPE process P2.

The c-plane GaN substrate is a free-standing wafer including only a GaN single crystal, and has a c-plane surface which is a large-area surface parallel to the c-plane or slightly off-cut from the c-plane. The thickness of the c-plane single-crystal GaN substrate can be appropriately set between 300 µm and 1 mm according to the area of the c-plane surface.

In particular, regarding the above <Fourth Aspect>, a specific example is a process of grinding the GaN crystal obtained in the HVPE process P2 into a cylindrical shape and then slicing the main growth layer of the GaN crystal.

In the slicing process, a wafer having a main surface and a back surface is cut into a plurality of wafers having a predetermined thickness from the ground GaN crystal using a saw wire. At this time, regarding a slicing direction, it is essential to slice both crystal ends of the GaN crystal along the m-axis direction. When the slicing direction is the m-axis direction, the saw wire travels in the a-axis direction, and a main cutting surface is the m-plane or a plane inclined from the m-plane to the c-axis direction. The m-plane of the GaN crystal is a cleavage plane, and therefore, it is considered that cutting is easy, and the saw wire is unlikely to deviate from the slicing direction. For the above reason, the absolute value of BOW in the slice direction, that is, the a-axis BOW and the m-axis BOW is reduced. Accordingly, a GaN substrate in which the absolute values of the a-axis BOW and the m-axis BOW are within a certain range and warpage is prevented over the entire substrate is obtained.

Preferred cutting conditions for the GaN substrate by the wire saw are shown below.
- Saw wire: diamond abrasive grain electrodeposited wire
- Outer diameter of saw wire: 0.20 mm to 0.30 mm
- Slicing speed of wire: 10 mm/min to 25 mm/min
- Wire traveling speed: 20 m/min to 400 m/min
- Slicing swing angle: 2.5°
- Wire tension: 30 N to 40 N

In the above <First Aspect> to <Fourth Aspect>, the c-plane GaN substrate obtained from the GaN crystal grown by the above method may be used as a seed used in the HVPE process to grow the GaN crystal according to the processes described above. That is, in this case, the c-plane GaN substrate obtained by the above method is used as a seed instead of the GaN template prepared in the GaN template preparation process P1 described above.

When the c-plane GaN substrate obtained by the above method is used as the seed, the process of growing the initial layer in the HVPE process P2 is omitted, and the process of growing the intermediate layer on the seed by the HVPE method (hereinafter, the intermediate layer in this case may be referred to as an "initial c-plane growth layer" for distinction) can be started. The subsequent processes can be performed in the same manner as in the case where the GaN template is used as the seed described above.

When the c-plane GaN substrate obtained by the above method is used as the seed, the crystal quality of the GaN substrate finally obtained can be further improved. Specifically, a GaN substrate having a further reduced dislocation density of the main surface or a GaN substrate having a smaller off-angle distribution is obtained.

### 3. Use of GaN Substrate

The c-plane GaN substrate according to the embodiments can be used for production of various nitride semiconductor devices including a light-emitting device such as a light-emitting diode (LED) and a laser diode (LD), and an electronic device such as a rectifier, a bipolar transistor, a field effect transistor, and a high electron mobility transistor (HEMT).

The nitride semiconductor is also referred to as a nitride-based Group III-V compound semiconductor, a group III nitride-based compound semiconductor, a GaN-based semiconductor, or the like, and includes not only GaN but also a compound obtained by substituting a part or all of gallium of GaN with other Group 13 elements (B, Al, In, or the like) of the periodic table.

The nitride semiconductor device is a semiconductor device in which a main portion of a device structure is formed of a nitride semiconductor.

### [Example 1]

The results of experiments conducted by the present inventors are described below.

### <Example 1-1>

A GaN template was prepared by epitaxially growing a c-axis oriented GaN film having a thickness of about 3 µm on a c-plane sapphire substrate having a diameter of 76 mm by an MOCVD method. A surface of the GaN film had a Ga polarity and a dislocation density on the order of 10⁸ cm⁻².

A SiNₓ film having a thickness of 800 Å was deposited on the surface of the GaN film by a plasma CVD method, and the SiNₓ film was patterned by photolithography and dry etching to form a separation layer having a triangular lattice net pattern and an aperture ratio of 40%. A GaN crystal was grown by HVPE using the pattern-mask-attached GaN template with the separation layer as a seed.

For the growth of the GaN crystal, a normal pressure HVPE apparatus including a quartz hot wall reactor, and a quartz gallium boat and a pyrolytic graphite susceptor disposed in the quartz hot wall reactor was used. In the HVPE apparatus, a foreign matter adhesion preventing cover was provided in a space immediately above the seed in order to prevent foreign matter from adhering onto the crystal being grown.

While the temperature of the gallium boat was maintained at 850°C from start to end, a GaN crystal including an initial layer, an intermediate layer, a pitted layer, a planarized layer, and a main growth layer was grown under the conditions shown in Table 1 below. As a carrier gas, H₂ (hydrogen gas) and N₂ (nitrogen gas) were used.

### [Table 1]

**Table 1**

| | Growth temperature [°C] | Growth rate [µm/min] | V/III ratio |
|---|---|---|---|
| Initial layer | 900 to 980 | 150 | 2 |
| Intermediate layer | 1000 to 1100 | 100 | 5 |
| Pitted layer | 900 to 980 | 150 | 3 |
| Planarized layer | 1000 to 1100 | 100 | 3 |
| Main growth layer | 1000 to 1100 | 100 | 6 |

The V/III ratio in Table 1 is a molar flow rate ratio of NH₃ (ammonia) supplied into the reactor and a molar flow rate ratio of HCl (hydrogen chloride) supplied to the gallium boat.

First, the initial layer was grown, and then the intermediate layer was grown. Subsequently, the pitted layer and the planarized layer were alternately grown, and finally, the main growth layer was grown.

The initial layer is a layer grown such that a facet surface appears on the GaN template, and the intermediate layer is a layer grown subsequent to the initial layer and is a layer obtained by eliminating the facet surface of the initial layer and being flattened. In the process of growing the intermediate layer, a molar ratio of H₂ in the carrier gas was set to 0.05 or more. Here, the molar ratio of H₂ in the carrier gas is a value calculated based on the molar flow rates of H₂ and N₂ supplied from the outside of the reactor into the reactor.

The pitted layer is a layer in which facet surfaces appear on the growth surface and numerous pits are formed.

The planarized layer is a layer grown subsequent to each pitted layer.

After the GaN crystal layer was grown as the pitted layer, when the crystal growth conditions were changed to the growth conditions for the planarized layer, the growth conditions were gradually changed while continuing the crystal growth without stopping the supply of the raw gas. That is, the growth conditions for the pitted layer were continuously changed to the growth conditions for the planarized layer. Specifically, the growth temperature and the V/III ratio were gradually changed over 10 minutes while the supply of the raw gas was kept.

The pitted layer and the planarized layer were alternately grown, and this operation was repeated a plurality of times.

After the growth of the main growth layer, the reactor temperature was lowered to room temperature, and the GaN template and the GaN crystal grown thereon were taken out of the reactor and observed. It was found that the separation between the two was essentially completed within the reactor.

After the outer periphery of the grown GaN crystal was processed into a cylindrical shape, a wafer having a main surface substantially parallel to the c-plane was sliced from the main growth layer portion. The main surface on the Ga polarity side and the back surface on the N polarity side of the wafer were planarized by grinding and then subjected to chemical mechanical polishing to remove a damaged layer. Thus, a c-plane GaN substrate having a diameter of 5 cm (about 2 inches) and a thickness of 400 µm was completed.

For the main surface (first main surface) on the Ga polarity side of the c-plane GaN substrate, the number of local strains in the main surface was examined by crossed Nicols image observation acquired by a sensitive color method, and the local strain density was measured.

The acquisition conditions for the crossed Nicols image were as follows.

The double-sided polished c-plane GaN substrate was placed on an upper surface of a polarized LED light box, and a high-transmittance sensitive color plate was placed on an upper portion of the c-plane GaN substrate. The c-plane GaN substrate was irradiated with an LED light and imaged with a digital camera through the sensitive color plate to acquire a crossed Nicols image. For the measurement, an LED rainbow viewer (manufactured by MeCan Imaging inc.), which was a polarization strain inspection apparatus, was used. The portion having strains changes to shades of blue, or orange/yellow. A part having no strains appears purple, just like the entire field of view. In the case where both surfaces of the GaN substrate of the sample are not polished or one surface thereof is polished, there are cases where incident light does not pass through the GaN substrate, making an appropriate measurement impossible. In this case, the main surface on the unpolished side of the GaN substrate is polished to allow incident light to transmit, making the crossed Nicols measurement possible.

The measurement was performed at room temperature (around 25°C). The refractive index of gallium nitride is common to be temperature dependent, and there are cases where the temperature during the measurement greatly deviates from room temperature, making the appropriate measurement impossible. Therefore, the crossed Nicols measurement is preferably performed at room temperature (around 25°C).

FIG. 6 is an enlarged view of the vicinity of the local strains in the obtained crossed Nicols image. In FIG. 6, a region surrounded by a dotted line is a region in which local strains are observed, and the local strains were observed as a slightly cloverleaf-shaped discolored regions with a diameter of 500 µm to 2500 µm.

The dislocation density of the main surface on the Ga polarity side of the c-plane GaN substrate was examined by cathode luminescence (CL) image observation.

A normal direction of the main surface was set as the z direction, and a direction perpendicular to the z direction and parallel to one of a-planes was selected as the x direction. The dislocation density was measured on a first line passing through a center of the main surface and extending in the x direction and a second line passing through the center of the main surface and extending in the y direction perpendicular to the x direction.

The measurement was performed at 17 points in total, that is, an intersection point (= center of the main surface) between the first line and the second line, eight points on the first line excluding the intersection point, and eight points on the second line excluding the intersection point. The interval between adjacent measurement points was 5 mm.

A rectangular area of 180 µm × 240 µm was observed at each measurement point, and the dislocation density was calculated for each measurement point by dividing the number of dislocations found in the rectangular area by the area (43200 µm²) of the rectangular area. An average value of the dislocation densities at 17 measurement points was taken as the dislocation density of the main surface of the c-plane GaN substrate.

In addition, a fluctuation range of the x-direction component of the off-cut angle in the section of 40 mm on the first line and a fluctuation range of the y-direction component of the off-cut angle in the section of 40 mm on the second line were examined using an X-ray diffraction apparatus.

### <Example 1-2>

A GaN crystal was grown by HVPE using the c-plane GaN substrate obtained in Example 1-1 as a seed.

For the growth of the GaN crystal, an HVPE apparatus of the same type as that used in Example 1-1 was used except that the foreign matter adhesion preventing cover was not disposed.

While the temperature of the gallium boat was maintained at 850°C from start to end, a GaN crystal including an initial layer, a pitted layer, a planarized layer, and a main growth layer was grown under the conditions shown in Table 2 below. As a carrier gas, H₂ (hydrogen gas) and N₂ (nitrogen gas) were used.

### [Table 2]

**Table 2**

| | Growth temperature [°C] | Growth rate [µm/min] | V/III ratio |
|---|---|---|---|
| Initial c-plane growth layer | 1000 to 1100 | 100 | 3 |
| Pitted layer | 900 to 980 | 150 | 3 |
| Planarized layer | 1000 to 1100 | 100 | 3 |
| Main growth layer | 1000 to 1100 | 100 | 6 |

First, an initial c-plane growth layer was grown, and subsequently, the pitted layer and the planarized layer were alternately grown, followed by growing the main growth layer. As in Example 1-1, the transition from the pitted layer to the planarized layer was continuously performed while continuing the crystal growth. The alternative growth of the pitted layer and the planarized layer was repeated a plurality of times.

A c-plane GaN substrate having the same diameter and thickness as that prepared in Example 1-1 was prepared from the main growth layer part of the grown GaN crystal, and the density of local strains in the main surface on the Ga polarity side, the dislocation density, and the fluctuation of the off-cut angle were evaluated in the same procedure as in Example 1-1.

### <Example 1-3>

A GaN crystal was grown in the same manner as in Example 1-1 except that the transition from the growth conditions for the pitted layer to the growth conditions for the planarized layer was performed discontinuously.

That is, in Example 1-3, after the GaN crystal layer was grown as the pitted layer, the supply of the raw gas was stopped, and the crystal growth was temporarily stopped before the crystal growth conditions were changed to the growth conditions for the planarized layer. Thereafter, the growth conditions were changed to the growth conditions for the planarized layer. Thereafter, the supply of the raw gas was restarted, and the crystal growth of the planarized layer was resumed.

A c-plane GaN substrate having the same diameter and thickness as that prepared in Example 1-1 was prepared from the main growth layer part of the grown GaN crystal, and the density of local strains in the main surface on the Ga polarity side, the dislocation density, and the fluctuation of the off-cut angle were evaluated in the same procedure as in Example 1-1.

### <Example 1-4>

A GaN crystal was grown in the same manner as in Example 1-1 except that the foreign matter adhesion preventing cover was not disposed in the used HVPE apparatus.

A c-plane GaN substrate having the same diameter and thickness as that prepared in Example 1-1 was prepared from the main growth layer part of the grown GaN crystal, and the density of local strains in the main surface on the Ga polarity side, the dislocation density, and the fluctuation of the off-cut angle were evaluated in the same procedure as in Example 1-1.

### <Comparative Example 1-1>

A GaN crystal was grown in the same manner as in Example 1-1, except that, the foreign matter adhesion preventing cover was not disposed in the used HVPE apparatus, the GaN crystal including the initial layer, the intermediate layer, the pitted layer, the planarized layer, and the main growth layer was grown under the conditions shown in Table 3 below, the molar ratio of H₂ in the carrier gas was set to less than 0.05 in the process of growing the intermediate layer, and the transition from the growth conditions for the pitted layer to the growth conditions for the planarized layer were discontinuously performed.

Specifically, after the GaN crystal layer was grown as the pitted layer, the supply of the raw gas was stopped, and the crystal growth was temporarily stopped before the crystal growth conditions were changed to the growth conditions for the planarized layer. Thereafter, the growth conditions were changed to the growth conditions for the planarized layer. Thereafter, the supply of the raw gas was restarted, and the crystal growth of the planarized layer was resumed.

A c-plane GaN substrate having the same diameter and thickness as that prepared in Example 1-1 was prepared from the main growth layer part of the grown GaN crystal, and the density of local strains in the main surface on the Ga polarity side, the dislocation density, and the fluctuation of the off-cut angle were evaluated in the same procedure as in Example 1-1.

### [Table 3]

**Table 3**

| | Growth temperature [°C] | Growth rate [µm/min] | V/III ratio |
|---|---|---|---|
| Initial layer | 900 to 980 | 150 | 2 |
| Intermediate layer | 1000 to 1100 | 100 | 5 |
| Pitted layer | 900 to 980 | 150 | 3 |
| Planarized layer | 1000 to 1100 | 100 | 3 |
| Main growth layer | 1000 to 1100 | 100 | 6 |

### <Comparative Example 1-2>

A GaN crystal was grown by HVPE using the c-plane GaN substrate obtained in Comparative Example 1-1 as a seed.

For the growth of the GaN crystal, an HVPE apparatus of the same type as that used in Example 1-1 was used except that the foreign matter adhesion preventing cover was not disposed.

While the temperature of the gallium boat was maintained at 850°C from start to end, a GaN crystal including an initial c-plane growth layer, a pitted layer, a planarized layer, and a main growth layer was grown under the same conditions as those shown in Table 2. As a carrier gas, H₂ (hydrogen gas) and N₂ (nitrogen gas) were used.

First, an initial c-plane growth layer was grown, and subsequently, the pitted layer and the planarized layer were alternately grown, followed by growing the main growth layer. Unlike Example 1-2, the transition from the growth conditions for the pitted layer to the growth conditions for the planarized layer was performed discontinuously.

Specifically, after the GaN crystal layer was grown as the pitted layer, the supply of the raw gas was stopped, and the crystal growth was temporarily stopped before the crystal growth conditions were changed to the growth conditions for the planarized layer. Thereafter, the growth conditions were changed to the growth conditions for the planarized layer. Thereafter, the supply of the raw gas was restarted, and the crystal growth of the planarized layer was resumed.

The alternate growth of the pitted layer and the planarized layer was repeated the same number of times as in Example 1-2.

A c-plane GaN substrate having the same diameter and thickness as that prepared in Example 1-1 was prepared from the main growth layer part of the grown GaN crystal, and the density of local strains in the main surface on the Ga polarity side, the dislocation density, and the fluctuation of the off-cut angle were evaluated in the same procedure as in Example 1-1.

The evaluation results of the c-plane GaN substrates obtained in Examples 1-1 to 1-4 and Comparative Examples 1-1 and 1-2 are shown in Table 4 below.

### [Table 4]

**Table 4**

| | Example 1-1 | Example 1-2 | Example 1-3 | Example 1-4 | Comparative Example 1-1 | Comparative Example 1-2 |
|---|---|---|---|---|---|---|
| Number density of local strains [counts/cm²] | 0.03 | 0.05 | 0.20 | 0.25 | 0.59 | 0.74 |
| Dislocation density [cm⁻²] | 8.20×10⁵ | 4.20×10⁵ | 8.90×10⁵ | 9.10×10⁵ | 1.10×10⁶ | 5.70×10⁵ |
| Off-cut angle fluctuation range [°] | 0.08 | 0.02 | 0.1 | 0.09 | 0.1 | 0.05 |

As shown in Table 4, in the GaN substrates of Examples 1-1 to 1-4, the number density of local strains in the main surface was greatly reduced when the GaN substrates are c-plane GaN substrates. In addition, in the GaN substrates of Examples 1-1 to 1-4, at least one 2.5 cm × 2.5 cm square lattice in which no local strain was observed was found. In addition, in the GaN substrates of Examples 1-1 to 1-3, at least one 3 cm × 3 cm square lattice in which no local strain was observed was found. On the other hand, in the GaN substrates of Comparative Examples 1-1 and 1-2, no 2.5 cm × 2.5 cm square lattice in which no local strain was observed was found.

Accordingly, when the GaN substrates of Examples 1-1 to 1-4 are used as LD substrates, deterioration in the LD production yield can be prevented. In the GaN substrates of Examples 1-1 to 1-4, in addition to the reduction in local strains in the main surface, the dislocation density was low, and the fluctuation range of the off-cut angle was small. That is, it can be said that the GaN crystal has both reduced local strain in the main surface and excellent crystal quality. The fluctuation range of the off-cut angle in Table 4 indicates the largest fluctuation range of the fluctuation range of the x-direction component and the fluctuation range of the y-direction component.

The impurity concentration of the GaN substrate of Example 1-1 was measured by secondary ion mass spectrometry (SIMS). The Si concentration was 2 × 10¹⁸ cm⁻³. The O concentration was 2 × 10¹⁶ cm⁻³.

The H concentration was less than 1 × 10¹⁷ cm⁻³.

In above Example 1-1, the GaN template in which the SiNₓ film having the periodic opening pattern was provided as the separation layer is used as the seed, but instead of this, a seed with a separation layer used in a so-called VAS method [Y. Oshima, et al., Japanese Journal of Applied Physics 42 (2003) pp. L1-L3] may be used. The seed with a separation layer can be obtained by growing a GaN layer having a thickness of several hundreds of nanometers on a sapphire substrate via a low-temperature buffer layer by a metalorganic vapor phase epitaxy (MOVPE) method, further forming a Ti (titanium) layer having a thickness of several tens of nanometers thereon by vacuum deposition, and then performing annealing in a mixed gas of 80% H₂ (hydrogen gas) and 20% NH₃ (ammonia), for example, at 1060°C for 30 minutes.

### <Example 2-1>

A c-plane GaN substrate having a diameter of 5 cm (about 2 inches) and a thickness of 400 µm was completed in the same manner as in Example 1-1.

For the main surface (first main surface) on the Ga polarity side of the c-plane GaN substrate, a photoelastic strain in the main surface was measured by the photoelasticity measurement. The conditions for the photoelasticity measurement were as follows.

As the photoelastic apparatus, an apparatus developed by the authors of Non-Patent Literature 1 to Non-Patent Literature 3 described above was used. FIG. 7 is a schematic diagram of the apparatus.

In the photoelasticity measurement, an LED having a wavelength of 633 nm was used as an incident light source, light passing through a rotary polarizer was incident along a normal direction of a c-plane of a c-plane gallium nitride substrate as a substrate to be measured, and a transmitted light intensity in each location in a plane was detected by a CCD camera through a rotary analyzer. The substrate to be measured is required to be subjected to double-sided polishing so as to transmit light.

In the case where both surfaces of the c-plane GaN substrate of the sample are not polished or one surface thereof is polished, incident light does not pass through the GaN substrate, and an appropriate measurement cannot be performed. In this case, the main surface on the unpolished side of the GaN substrate is polished to allow incident light to transmit, making the photoelasticity measurement possible.

In the photoelasticity measurement, the transmitted light intensity was measured while synchronously rotating the rotary polarizer and the rotary analyzer under the perpendicular condition and the parallel condition, but the light amount was adjusted such that the transmitted light intensity exceeded the detection intensity of the CCD camera and was not saturated, and the number of divisions of the polarization angle of each of the rotary polarizer and the rotary analyzer was set to 25 or more. The in-plane resolution of the CCD camera, that is, the pixel size was 167 µm in both the vertical and horizontal directions.

The phase difference δ which is the amount of birefringence at each location in the plane and the principal axis azimuth angle ψ are determined according to the polarization analysis using the following equation described above.$\begin{matrix}δ = 2 {sin}^{- 1} \left[16\left({I}_{sin}^{2}+{I}_{cos}^{2}\right)\right] \\ ψ = \frac{1}{4} {tan}^{- 1} \frac{{I}_{sin}}{{I}_{cos}} \\ {I}_{sin} = \frac{1}{J} {\sum }_{j}^{J - 1} {I}_{r} \left({ϕ}_{j}\right) sin 4 {ϕ}_{j} = - \frac{1}{4} sin 4 {ψsin}^{2} \frac{δ}{2} \\ {I}_{cos} = \frac{1}{J} {\sum }_{j}^{J - 1} {I}_{r} \left({ϕ}_{j}\right) cos 4 {ϕ}_{j} = - \frac{1}{4} cos 4 {ψsin}^{2} \frac{δ}{2}\end{matrix}$

Then, an in-plane distribution of |Sᵣ-Sₜ|, which is a strain evaluation value represented by the following formula, was determined and evaluated with the thickness of the substrate to be measured and a strain-free refractive index of gallium nitride with respect to a light source wavelength of 633 nm as 2.355 and a photoelastic tensor component |p₁₁ - p₁₂| = 0.13. $\left|{S}_{r}-{S}_{t}\right| = {\left[{\left({S}_{yy}-{S}_{xx}\right)}^{2}+{\left(2{S}_{xy}\right)}^{2}\right]}^{\frac{1}{2}}$

The measurement was performed at room temperature (around 25°C). The refractive index of gallium nitride is common to be temperature dependent, and there are cases where the temperature during the measurement greatly deviates from room temperature, making the appropriate measurement impossible. Therefore, the photoelasticity measurement is preferably performed at room temperature (around 25°C).

Further, as in <Example 1-1>, the dislocation density of the main surface on the Ga polarity side of the c-plane GaN substrate was examined by cathode luminescence (CL) image observation.

A normal direction of the main surface was set as the z direction, and a direction perpendicular to the z direction and parallel to one of a-planes was selected as the x direction. The dislocation density was measured on a first line passing through a center of the main surface and extending in the x direction and a second line passing through the center of the main surface and extending in the y direction perpendicular to the x direction.

The measurement was performed at 17 points in total, that is, an intersection point (= center of the main surface) between the first line and the second line, eight points on the first line excluding the intersection point, and eight points on the second line excluding the intersection point. The interval between adjacent measurement points was 5 mm.

A rectangular area of 180 µm × 240 µm was observed at each measurement point, and the dislocation density was calculated for each measurement point by dividing the number of dislocations found in the rectangular area by the area (43200 µm²) of the rectangular area. An average value of the dislocation densities at 17 measurement points was taken as the dislocation density of the main surface of the c-plane GaN substrate.

In addition, a fluctuation range of the x-direction component of the off-cut angle in the section of 40 mm on the first line and a fluctuation range of the y-direction component of the off-cut angle in the section of 40 mm on the second line were examined using an X-ray diffraction apparatus.

### <Example 2-2>

A GaN crystal was grown by HVPE using the c-plane GaN substrate obtained in Example 2-1 as a seed under the same conditions as those for growing a GaN crystal by HVPE using the c-plane GaN substrate obtained in Example 1-1 as a seed in Example 1-2.

A c-plane GaN substrate having the same diameter and thickness as that prepared in Example 2-1 was prepared from the main growth layer part of the grown GaN crystal, and the strain evaluation value determined by the photoelasticity measurement for the main surface on the Ga polarity side, and the fluctuation in dislocation density and off-cut angle were evaluated in the same procedure as in Example 2-1.

### <Example 2-3>

A GaN crystal was grown in the same manner as in Example 2-1 except that the transition from the growth conditions for the pitted layer to the growth conditions for the planarized layer was performed discontinuously.

That is, in Example 2-3, after the GaN crystal layer was grown as the pitted layer, the supply of the raw gas was stopped, and the crystal growth was temporarily stopped before the crystal growth conditions were changed to the growth conditions for the planarized layer. Thereafter, the growth conditions were changed to the growth conditions for the planarized layer. Thereafter, the supply of the raw gas was restarted, and the crystal growth of the planarized layer was resumed.

A c-plane GaN substrate having the same diameter and thickness as that prepared in Example 2-1 was prepared from the main growth layer part of the grown GaN crystal, and the strain evaluation value determined by the photoelasticity measurement for the main surface on the Ga polarity side, and the fluctuation in dislocation density and off-cut angle were evaluated in the same procedure as in Example 2-1.

### <Example 2-4>

A GaN crystal was grown in the same manner as in Example 2-1 except that the foreign matter adhesion preventing cover was not disposed in the used HVPE apparatus.

A c-plane GaN substrate having the same diameter and thickness as that prepared in Example 2-1 was prepared from the main growth layer part of the grown GaN crystal, and the strain evaluation value determined by the photoelasticity measurement for the main surface on the Ga polarity side, and the fluctuation in dislocation density and off-cut angle were evaluated in the same procedure as in Example 2-1.

### <Comparative Example 2-1>

A GaN crystal was grown in the same manner as in Example 2-1 except that, the foreign matter adhesion preventing cover was not disposed in the used HVPE apparatus, the GaN crystal including the initial layer, the intermediate layer, the pitted layer, the planarized layer, and the main growth layer was grown under the same conditions as Comparative Example 1-1, the molar ratio of H₂ in the carrier gas was set to less than 0.05 in the process of growing the intermediate layer, and the transition from the growth conditions for the pitted layer to the growth conditions for the planarized layer were discontinuously performed.

Specifically, after the GaN crystal layer was grown as the pitted layer, the supply of the raw gas was stopped, and the crystal growth was temporarily stopped before the crystal growth conditions were changed to the growth conditions for the planarized layer. Thereafter, the growth conditions were changed to the growth conditions for the planarized layer. Thereafter, the supply of the raw gas was restarted, and the crystal growth of the planarized layer was resumed.

A c-plane GaN substrate having the same diameter and thickness as that prepared in Example 2-1 was prepared from the main growth layer part of the grown GaN crystal, and the strain evaluation value determined by the photoelasticity measurement for the main surface on the Ga polarity side, and the fluctuation in dislocation density and off-cut angle were evaluated in the same procedure as in Example 2-1.

### <Comparative Example 2-2>

A GaN crystal was grown by HVPE using the c-plane GaN substrate obtained in Comparative Example 2-1 as a seed.

For the growth of the GaN crystal, an HVPE apparatus of the same type as that used in Example 2-1 was used except that the foreign matter adhesion preventing cover was not disposed.

While the temperature of the gallium boat was maintained at 850°C from start to end, a GaN crystal including an initial c-plane growth layer, a pitted layer, a planarized layer, and a main growth layer was grown under the same conditions as those shown in Table 2. As a carrier gas, H₂ (hydrogen gas) and N₂ (nitrogen gas) were used.

First, an initial c-plane growth layer was grown, and subsequently, the pitted layer and the planarized layer were alternately grown, followed by growing the main growth layer. Unlike Example 2-2, the transition from the growth conditions for the pitted layer to the growth conditions for the planarized layer was performed discontinuously.

Specifically, after the GaN crystal layer was grown as the pitted layer, the supply of the raw gas was stopped, and the crystal growth was temporarily stopped before the crystal growth conditions were changed to the growth conditions for the planarized layer. Thereafter, the growth conditions were changed to the growth conditions for the planarized layer. Thereafter, the supply of the raw gas was restarted, and the crystal growth of the planarized layer was resumed.

The alternate growth of the pitted layer and the planarized layer was repeated the same number of times as in Example 2-2.

A c-plane GaN substrate having the same diameter and thickness as that prepared in Example 2-1 was prepared from the main growth layer part of the grown GaN crystal, and the strain evaluation value determined by the photoelasticity measurement for the main surface on the Ga polarity side, and the fluctuation in dislocation density and off-cut angle were evaluated in the same procedure as in Example 2-1.

The evaluation results of the c-plane GaN substrates obtained in Examples 2-1 to 2-4 and Comparative Examples 2-1 and 2-2 are shown in Table 5 below. In Table 5, a threshold value of the strain evaluation value was set to 6 × 10⁻⁵

### [Table 5]

**Table 5**

| | | Example 2-1 | Example 2-2 | Example 2-3 | Example 2-4 | Comparative Example 2-1 | Comparative Example 2-2 |
|---|---|---|---|---|---|---|---|
| Strain evaluation value | Maximum value | 2.82E-05 | 3.40E-05 | 4.61E-05 | 3.62E-05 | 1.25E-04 | 1.29E-04 |
| | Ratio of area (S1) | 0.0% | 0.0% | 0.0% | 0.0% | 0.13% | 0.39% |
| | Area (S1) /area (S2) | 0.0% | 0.0% | 0.0% | 0.0% | 71.6% | 68.6% |
| Dislocation density [cm⁻²] | | 8.20E+05 | 4.20E+05 | 8.90E+05 | 9.10E+05 | 1.10E+06 | 5.70E+05 |
| Off-cut angle fluctuation range [°] | | 0.08 | 0.02 | 0.1 | 0.09 | 0.1 | 0.05 |

As shown in Table 5, in the GaN substrates of Examples 2-1 to 2-4, the local strain in the main surface is greatly reduced when the GaN substrates are c-plane GaN substrates. As a result, when the GaN substrates of Examples 2-1 to 2-4 are used as LD substrates, deterioration in the LD production yield can be prevented. In the GaN substrates of Examples 2-1 to 2-4, in addition to the reduction in local strains in the main surface, the dislocation density was low, and the fluctuation range of the off-cut angle was small. That is, it can be said that the GaN crystal has both reduced local strain in the main surface and excellent crystal quality. The fluctuation range of the off-cut angle in Table 5 indicates the largest fluctuation range of the fluctuation range of the x-direction component and the fluctuation range of the y-direction component.

The impurity concentration of the GaN substrate of Example 2-1 was measured by secondary ion mass spectrometry (SIMS). The Si concentration was 2 × 10¹⁸ cm⁻³. The O concentration was 2 × 10¹⁶ cm⁻³.

The H concentration was less than 1 × 10¹⁷ cm⁻³.

In above Example 2-1, the GaN template in which the SiNₓ film having the periodic opening pattern is provided as the separation layer is used as the seed, but instead of this, a seed with a separation layer used in a so-called VAS method [Y. Oshima, et al., Japanese Journal of Applied Physics 42 (2003) pp. L1-L3] may be used. The seed with a separation layer can be obtained by growing a GaN layer having a thickness of several hundreds of nanometers on a sapphire substrate via a low-temperature buffer layer by a metalorganic vapor phase epitaxy (MOVPE) method, further forming a Ti (titanium) layer having a thickness of several tens of nanometers thereon by vacuum deposition, and then performing annealing in a mixed gas of 80% H₂ (hydrogen gas) and 20% NH₃ (ammonia), for example, at 1060°C for 30 minutes.

### <Example 3-1>

A c-plane GaN substrate having a diameter of 5 cm (about 2 inches) and a thickness of 400 µm was completed in the same manner as in Example 1-1.

For the main surface (first main surface) on the Ga polarity side of the c-plane GaN substrate, the number of pits in the main surface was examined by optical microscope observation, and the number density of pits was measured.

Further, as in <Example 1-1>, the dislocation density of the main surface on the Ga polarity side of the c-plane GaN substrate was examined by cathode luminescence (CL) image observation.

A normal direction of the main surface was set as the z direction, and a direction perpendicular to the z direction and parallel to one of a-planes was selected as the x direction. The dislocation density was measured on a first line passing through a center of the main surface and extending in the x direction and a second line passing through the center of the main surface and extending in the y direction perpendicular to the x direction.

The measurement was performed at 17 points in total, that is, an intersection point (= center of the main surface) between the first line and the second line, eight points on the first line excluding the intersection point, and eight points on the second line excluding the intersection point. The interval between adjacent measurement points was 5 mm.

A rectangular area of 180 µm × 240 µm was observed at each measurement point, and the dislocation density was calculated for each measurement point by dividing the number of dislocations found in the rectangular area by the area (43200 µm²) of the rectangular area. An average value of the dislocation densities at 17 measurement points was taken as the dislocation density of the main surface of the c-plane GaN substrate.

In addition, a fluctuation range of the x-direction component of the off-cut angle in the section of 40 mm on the first line and a fluctuation range of the y-direction component of the off-cut angle in the section of 40 mm on the second line were examined using an X-ray diffraction apparatus.

### <Example 3-2>

A GaN crystal was grown by HVPE using the c-plane GaN substrate obtained in Example 3-1 as a seed under the same conditions as those for growing a GaN crystal by HVPE using the c-plane GaN substrate obtained in Example 1-1 as a seed in Example 1-2.

A c-plane GaN substrate having the same diameter and thickness as that prepared in Example 3-1 was prepared from the main growth layer part of the grown GaN crystal, and the number density of pits in the main surface on the Ga polarity side, the dislocation density, and the fluctuation of the off-cut angle were evaluated in the same procedure as in Example 3-1.

### <Example 3-3>

A GaN crystal was grown in the same manner as in Example 3-1 except that the transition from the growth conditions for the pitted layer to the growth conditions for the planarized layer was performed discontinuously.

That is, in Example 3-3, after the GaN crystal layer was grown as the pitted layer, the supply of the raw gas was stopped, and the crystal growth was temporarily stopped before the crystal growth conditions were changed to the growth conditions for the planarized layer. Thereafter, the growth conditions were changed to the growth conditions for the planarized layer. Thereafter, the supply of the raw gas was restarted, and the crystal growth of the planarized layer was resumed.

A c-plane GaN substrate having the same diameter and thickness as that prepared in Example 3-1 was prepared from the main growth layer part of the grown GaN crystal, and the number density of pits in the main surface on the Ga polarity side, the dislocation density, and the fluctuation of the off-cut angle were evaluated in the same procedure as in Example 3-1.

### <Example 3-4>

A GaN crystal was grown in the same manner as in Example 3-1 except that the foreign matter adhesion preventing cover was not disposed in the used HVPE apparatus.

A c-plane GaN substrate having the same diameter and thickness as that prepared in Example 3-1 was prepared from the main growth layer part of the grown GaN crystal, and the number density of pits in the main surface on the Ga polarity side, the dislocation density, and the fluctuation of the off-cut angle were evaluated in the same procedure as in Example 3-1.

### <Comparative Example 3-1>

A GaN crystal was grown in the same manner as in Example 3-1 except that, the foreign matter adhesion preventing cover was not disposed in the used HVPE apparatus, the GaN crystal including the initial layer, the intermediate layer, the pitted layer, the planarized layer, and the main growth layer was grown under the same conditions as Comparative Example 1-1, the molar ratio of H₂ in the carrier gas was set to less than 0.05 in the process of growing the intermediate layer, and the transition from the growth conditions for the pitted layer to the growth conditions for the planarized layer were discontinuously performed.

Specifically, after the GaN crystal layer was grown as the pitted layer, the supply of the raw gas was stopped, and the crystal growth was temporarily stopped before the crystal growth conditions were changed to the growth conditions for the planarized layer. Thereafter, the growth conditions were changed to the growth conditions for the planarized layer. Thereafter, the supply of the raw gas was restarted, and the crystal growth of the planarized layer was resumed.

A c-plane GaN substrate having the same diameter and thickness as that prepared in Example 3-1 was prepared from the main growth layer part of the grown GaN crystal, and the number density of pits in the main surface on the Ga polarity side, the dislocation density, and the fluctuation of the off-cut angle were evaluated in the same procedure as in Example 3-1.

### <Comparative Example 3-2>

A GaN crystal was grown by HVPE using the c-plane GaN substrate obtained in Comparative Example 3-1 as a seed.

For the growth of the GaN crystal, an HVPE apparatus of the same type as that used in Example 3-1 was used except that the foreign matter adhesion preventing cover was not disposed.

While the temperature of the gallium boat was maintained at 850°C from start to end, a GaN crystal including an initial c-plane growth layer, a pitted layer, a planarized layer, and a main growth layer was grown under the same conditions as those shown in Table 2. As a carrier gas, H₂ (hydrogen gas) and N₂ (nitrogen gas) were used.

First, an initial c-plane growth layer was grown, and subsequently, the pitted layer and the planarized layer were alternately grown, followed by growing the main growth layer. Unlike Example 3-2, the transition from the growth conditions for the pitted layer to the growth conditions for the planarized layer was performed discontinuously.

Specifically, after the GaN crystal layer was grown as the pitted layer, the supply of the raw gas was stopped, and the crystal growth was temporarily stopped before the crystal growth conditions were changed to the growth conditions for the planarized layer. Thereafter, the growth conditions were changed to the growth conditions for the planarized layer. Thereafter, the supply of the raw gas was restarted, and the crystal growth of the planarized layer was resumed.

The alternate growth of the pitted layer and the planarized layer was repeated the same number of times as in Example 3-2.

A c-plane GaN substrate having the same diameter and thickness as that prepared in Example 3-1 was prepared from the main growth layer part of the grown GaN crystal, and the number density of pits in the main surface on the Ga polarity side, the dislocation density, and the fluctuation of the off-cut angle were evaluated in the same procedure as in Example 3-1.

The evaluation results of the c-plane GaN substrates obtained in Examples 3-1 to 3-4 and Comparative Examples 3-1 and 3-2 are shown in Table 6 below.

### [Table 6]

**Table 6**

| | Example 3-1 | Example 3-2 | Example 3-3 | Example 3-4 | Comparative Example 3-1 | Comparative Example 3-2 |
|---|---|---|---|---|---|---|
| Number density of pits [counts/cm²] | 0 | 0.05 | 0.05 | 0.15 | 0.30 | 0.35 |
| Dislocation density [cm⁻²] | 8.20×10⁵ | 4.20×10⁵ | 8.90×10⁵ | 9.10×10⁵ | 1.10×10⁶ | 5.70×10⁵ |
| Off-cut angle fluctuation range [°] | 0.08 | 0.02 | 0.1 | 0.09 | 0.1 | 0.05 |

As shown in Table 6, in the GaN substrates of Examples 3-1 to 3-4, the number density of pits in the main surface was greatly reduced when the GaN substrates are c-plane GaN substrates. In addition, in the GaN substrates of Examples 3-1 to 3-4, at least one 2.5 cm × 2.5 cm square lattice in which no pit was observed was found. In addition, in the GaN substrates of Examples 3-1 to 3-3, at least one 3 cm × 3 cm square lattice in which no pit was observed was found. On the other hand, in the GaN substrate of Comparative Examples 3-1 and 3-2, a 2.5 cm × 2.5 cm square lattice in which no pit was observed was not found.

As a result, when the GaN substrates of Examples 3-1 to 3-4 are used as LD substrates, deterioration in the LD production yield can be prevented. In the GaN substrates of Examples 3-1 to 3-4, in addition to the reduction in pits in the main surface, the dislocation density was low, and the fluctuation range of the off-cut angle was small. That is, it can be said that the GaN crystal has both reduced pits in the main surface and excellent crystal quality. The fluctuation range of the off-cut angle in Table 6 indicates the largest fluctuation range of the fluctuation range of the x-direction component and the fluctuation range of the y-direction component.

The impurity concentration of GaN in Example 3-1 was measured by secondary ion mass spectrometry (SIMS). The Si concentration was 2 × 10¹⁸ cm⁻³. The O concentration was 2 × 10¹⁶ cm⁻³. The H concentration was less than 1 × 10¹⁷ cm⁻³.

In Example 3-1, the GaN template in which the SiNₓ film having the periodic opening pattern is provided as the separation layer is used as the seed, but instead of this, a seed with a separation layer used in a so-called VAS method [Y. Oshima, et al., Japanese Journal of Applied Physics 42 (2003) pp. L1-L3] may be used. The seed with a separation layer can be obtained by growing a GaN layer having a thickness of several hundreds of nanometers on a sapphire substrate via a low-temperature buffer layer by a metalorganic vapor phase epitaxy (MOVPE) method, further forming a Ti (titanium) layer having a thickness of several tens of nanometers thereon by vacuum deposition, and then performing annealing in a mixed gas of 80% H₂ (hydrogen gas) and 20% NH₃ (ammonia), for example, at 1060°C for 30 minutes.

### <Example 4-1>

A GaN template was prepared by epitaxially growing a c-axis oriented GaN film having a thickness of about 3 µm on a c-plane sapphire substrate having a diameter of 76 mm by an MOCVD method. A surface of the GaN film had a Ga polarity and a dislocation density on the order of 10⁸ cm⁻².

A SiNₓ film having a thickness of 800 Å was deposited on the surface of the GaN film by a plasma CVD method, and the SiNₓ film was patterned by photolithography and dry etching to form a separation layer having a triangular lattice net pattern and an aperture ratio of 40%. A GaN crystal was grown by HVPE using the pattern-mask-attached GaN template with the separation layer as a seed.

For the growth of the GaN crystal, a normal pressure HVPE apparatus including a quartz hot wall reactor, and a quartz gallium boat and a pyrolytic graphite susceptor disposed in the quartz hot wall reactor was used. In the HVPE apparatus, a foreign matter adhesion preventing cover was provided in a space immediately above the seed in order to prevent foreign matter from adhering onto the crystal being grown.

While the temperature of the gallium boat was maintained at 850°C from start to end, a GaN crystal including an initial layer, an intermediate layer, a pitted layer, a planarized layer, and a main growth layer was grown under the conditions shown in Table 1 above. As a carrier gas, H₂ (hydrogen gas) and N₂ (nitrogen gas) were used.

First, the initial layer was grown, and then the intermediate layer was grown. Subsequently, the pitted layer and the planarized layer were alternately grown, and finally, the main growth layer was grown.

In the process of growing the intermediate layer, a molar ratio of H₂ in the carrier gas was set to 0.05 or more. Here, the molar ratio of H₂ in the carrier gas is a value calculated based on the molar flow rates of H₂ and N₂ supplied from the outside of the reactor into the reactor.

After the GaN crystal layer was grown as the pitted layer, when the crystal growth conditions were changed to the growth conditions for the planarized layer, the growth conditions were gradually changed while continuing the crystal growth without stopping the supply of the raw gas. That is, the growth conditions for the pitted layer were continuously changed to the growth conditions for the planarized layer. Specifically, the growth temperature and the V/III ratio were gradually changed over 10 minutes while the supply of the raw gas was kept.

The pitted layer and the planarized layer were alternately grown, and this operation was repeated a plurality of times.

After the growth of the main growth layer, the reactor temperature was lowered to room temperature, and the GaN template and the GaN crystal grown thereon were taken out of the reactor and observed. It was found that the separation between the two was essentially completed within the reactor.

After the outer periphery of the grown GaN crystal was processed into a cylindrical shape, a wafer having a main surface substantially parallel to the c-plane was sliced from the main growth layer portion. The main surface on the Ga polarity side and the back surface on the N polarity side of the wafer were planarized by grinding and then subjected to chemical mechanical polishing to remove a damaged layer. Thus, a c-plane GaN substrate seed having a diameter of 5 cm (about 2 inches) and a thickness of 400 µm was obtained.

After the outer periphery of the grown GaN crystal was processed into a cylindrical shape, a wafer having a main surface substantially parallel to the c-plane was sliced from the main growth layer portion. The main surface on the Ga polarity side and the back surface on the N polarity side of the wafer were planarized by grinding and then subjected to chemical mechanical polishing to remove a damaged layer. Thus, a c-plane GaN substrate seed having a diameter of 5 cm (about 2 inches) and a thickness of 400 µm was obtained.

A GaN crystal was grown by HVPE using the obtained c-plane GaN substrate seed as a seed.

For the growth of the GaN crystal, an HVPE apparatus of the same type as that used for production of the c-plane GaN substrate seed was used except that the foreign matter adhesion preventing cover was not disposed.

While the temperature of the gallium boat was maintained at 850°C from start to end, a GaN crystal including an initial layer, a pitted layer, a planarized layer, and a main growth layer was grown under the conditions shown in Table 2 above. As a carrier gas, H₂ (hydrogen gas) and N₂ (nitrogen gas) were used.

First, an initial c-plane growth layer was grown, and subsequently, the pitted layer and the planarized layer were alternately grown, followed by growing the main growth layer. The transition from the pitted layer to the planarized layer was continuously performed while continuing the crystal growth. The alternative growth of the pitted layer and the planarized layer was repeated a plurality of times.

After the outer periphery of the grown GaN crystal was processed into a cylindrical shape, a wafer having a main surface substantially parallel to the c-plane was sliced from the main growth layer portion.

The conditions for slicing are as follows.
- Slicing direction: m-axis direction
- Saw wire: diamond abrasive grain electrodeposited wire
- Outer diameter of saw wire: 0.2 mm to 0.3 mm
- Slicing speed of wire: 10 mm/min to 20 mm/min
- Wire traveling speed: 300 m/min to 350 m/min
- Slicing swing angle: 2.5°
- Wire tension: 30 N to 40 N

The main surface on the Ga polarity side and the back surface on the N polarity side of the wafer were planarized by grinding and then subjected to chemical mechanical polishing to remove a damaged layer. Thus, a c-plane GaN substrate having a diameter of 5 cm (about 2 inches) and a thickness of 400 µm was completed.

The a-axis BOW and the m-axis BOW of the c-plane GaN substrate were measured as follows.

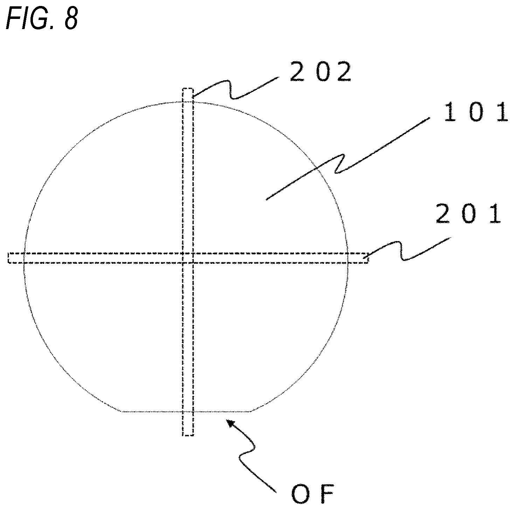

FIG. 8 is a schematic diagram of measurement portions on the c-plane GaN substrate.

A line having a width of 1 mm parallel to the a-axis passing through a center point of a main surface on the Ga polarity side of the c-plane GaN substrate was defined as a target region 1 (an a-axis BOW target region 202 in FIG. 8), a line having a width of 1 mm parallel to the m-axis passing through the center point of the main surface was defined as a target region 2 (an m-axis BOW target region 201 in FIG. 8), and the height of a substrate center from the least squares plane in this region was calculated. The a-axis BOW and the m-axis BOW were obtained by assigning a plus sign to the numerical value in a case where the numerical value was above (convex upward) the least squares plane and assigning a minus sign to the numerical value in a case where the numerical value was below (convex downward) the least squares plane.

The a-axis BOW was 0.02 µm. The m-axis BOW was 0.4 µm.

A flatness measuring device manufactured by Tropel was used for the measurement of BOW.

In addition, a fluctuation range of the x-direction component of the off-cut angle in the section of 40 mm on the first line and a fluctuation range of the y-direction component of the off-cut angle in the section of 40 mm on the second line were examined using an X-ray diffraction apparatus.

The fluctuation range of the off-cut angle was 0.009° in the x direction and 0.024° in the y direction.

### <Comparative Example 4-1>

A c-plane GaN substrate was obtained in the same manner as in Example 4-1 except that the slicing conditions were changed as follows when the c-plane GaN substrate was obtained by slicing the GaN crystal.

The slicing conditions were the same as those in Example 4-1 except that the slicing direction was the a-axis direction.

The a-axis BOW, the m-axis BOW, and the fluctuation range of the off-cut angle of the c-plane GaN substrate were evaluated in the same manner as in Example 4-1.

The a-axis BOW was -0.86 µm. The m-axis BOW was -2.87 µm.

The fluctuation range of the off-cut angle was 0.050° in the x direction and 0.010° in the y direction.

### <Comparative Example 4-2>

A c-plane GaN substrate was obtained in the same manner as in Example 4-1 except that the slicing conditions were changed as follows when the c-plane GaN substrate was obtained by slicing the GaN crystal.

The slicing conditions were the same as those in Example 4-1 except that the slicing direction was the a-axis direction.

The a-axis BOW, the m-axis BOW, the dislocation density, and the fluctuation range of the off-cut angle of the c-plane GaN substrate were evaluated in the same manner as in Example 4-1.

The a-axis BOW was 1.06 µm. The m-axis BOW was -2.61 µm.

The fluctuation range of the off-cut angle was 0.060° in the x direction and 0.015° in the y direction.

As described above, the present invention has been described with reference to specific embodiments. However, these embodiments are presented as examples and do not limit the scope of the present invention. These embodiments described in the present description can be variously modified without departing from the gist of the invention, and can be combined with the features described in other embodiments within a feasible range.

The present application is based on a Japanese Patent Application No. 2023-030253 filed on February 28, 2023, a Japanese Patent Application No. 2023-030254 filed on February 28, 2023, a Japanese Patent Application No. 2023-030255 filed on February 28, 2023, and a Japanese Patent Application No. 2023-030257 filed on February 28, 2023, contents of which are incorporated herein by reference.

### REFERENCE SIGNS LIST

100 substrate
101 first main surface
102 second main surface
1 single crystal GaN (0001) substrate
2 GaN crystal
21 base layer
22 pitted layer
24 planarized layer
201 m-axis BOW target region
202 a-axis BOW target region
OF orientation flat (a-plane)

## Claims

1. A gallium nitride substrate comprising:
a main surface inclined by 0° to 20° from a (0001) plane and having an area of 15 cm² or more,
wherein the main surface has a dislocation density of 5 × 10⁶ cm⁻² or less, and
a number density of local strains in a crossed Nicols image obtained by a sensitive color method for the main surface is 0.5 counts·cm⁻² or less.

2. A gallium nitride substrate comprising:
a main surface inclined by 0° to 20° from a (0001) plane and having an area of 15 cm² or more,
wherein the main surface has a dislocation density of 5 × 10⁶ cm⁻² or less, and
at least one 2.5 cm × 2.5 cm square lattice in which no local strain is observed is findable in a crossed Nicols image obtained by a sensitive color method for the main surface.

3. A gallium nitride substrate comprising:
a main surface inclined by 0° to 20° from a (0001) plane and having an area of 15 cm² or more,
wherein a maximum value of a strain evaluation value in the main surface is 1 × 10⁻⁴ or less, the strain evaluation value being calculated by a photoelasticity measurement for the main surface based on the following formula (1):
[Math. 1] $STRAIN EVALUATION VALUE : \left|{S}_{r}-{S}_{t}\right| = {\left[{\left({S}_{yy}-{S}_{xx}\right)}^{2}+{\left(2{S}_{xy}\right)}^{2}\right]}^{\frac{1}{2}}$
wherein each term in the formula (1) is represented by the following formulae (2) and (3): $\begin{matrix}\left|{S}_{yy}-{S}_{xx}\right| = \frac{λδ}{{πdn}_{0}^{3}} \left|\frac{cos 2 ϕ}{{p}_{11} - {p}_{12}}\right| \left(2\right) \\ 2 \left|{S}_{xy}\right| = \left|\left({S}_{yy}-{S}_{xx}\right) tan 2ψ\right| \left(3\right)\end{matrix}$
wherein δ and ψ represent a phase difference which is a birefringence amount derived from a strain and a principal axis azimuth angle, respectively, λ represents a light source wavelength of a photoelasticity measurement apparatus, d represents a sample thickness, n₀ represents a strain-free refractive index with respect to the light source wavelength, |p₁₁ - p₁₂| represents a photoelastic tensor component, and among these, λ, n₀, and |p₁₁ - p₁₂| satisfy the following conditions: $λ = 633 nm ;$ ${n}_{0} = 2.355 ;$ and $\left|{p}_{11}-{p}_{12}\right| = 0.13 .$

4. A gallium nitride substrate comprising:
a main surface inclined by 0° to 20° from a (0001) plane and having an area of 15 cm² or more,
wherein an area (S1) in which a strain evaluation value is 6 × 10⁻⁵ or more is 0.10% or less of an area of the entire main surface, the strain evaluation value being calculated by a photoelasticity measurement for the main surface based on the following formula (1):
[Math. 3] $STRAIN EVALUATION VALUE : \left|{S}_{r}-{S}_{t}\right| = {\left[{\left({S}_{yy}-{S}_{xx}\right)}^{2}+{\left(2 {S}_{xy}\right)}^{2}\right]}^{\frac{1}{2}}$
wherein each term in the formula (1) is represented by the following formulae (2) and (3): $\begin{matrix}\left|{S}_{yy}-{S}_{xx}\right| = \frac{λδ}{{πdn}_{0}^{3}} \left|\frac{cos 2 ϕ}{{p}_{11} - {p}_{12}}\right| \left(2\right) \\ 2 \left|{S}_{xy}\right| = \left|\left({S}_{yy}-{S}_{xx}\right) tan 2ψ\right| \left(3\right)\end{matrix}$
wherein δ and ψ represent a phase difference which is a birefringence amount derived from a strain and a principal axis azimuth angle, respectively, λ represents a light source wavelength of a photoelasticity measurement apparatus, d represents a sample thickness, n₀ represents a strain-free refractive index with respect to the light source wavelength, |p₁₁ - p₁₂| represents a photoelastic tensor component, and among these, λ, n₀, and |p₁₁ - p₁₂| satisfy the following conditions: $λ = 633 nm ;$ ${n}_{0} = 2.355 ;$ and $\left|{p}_{11}-{p}_{12}\right| = 0.13 .$

5. A gallium nitride substrate comprising:
a main surface inclined by 0° to 20° from a (0001) plane and having an area of 15 cm² or more,
wherein a ratio (S1/S2) of an area (S1) in which a strain evaluation value is 6 × 10⁻⁵ or more to an area (S2) in which the strain evaluation value is 5 × 10⁻⁵ or more is 50% or less, the strain evaluation value being calculated by a photoelasticity measurement for the main surface based on the following formula (1):
[Math. 5] $STRAIN EVALUATION VALUE : \left|{S}_{r}-{S}_{t}\right| = {\left[{\left({S}_{yy}-{S}_{xx}\right)}^{2}+{\left(2 {S}_{xy}\right)}^{2}\right]}^{\frac{1}{2}}$
wherein each term in the formula (1) is represented by the following formulae (2) and (3): $\begin{matrix}\left|{S}_{yy}-{S}_{xx}\right| = \frac{λδ}{{πdn}_{0}^{3}} \left|\frac{cos 2 ϕ}{{p}_{11} - {p}_{12}}\right| \left(2\right) \\ 2 \left|{S}_{xy}\right| = \left|\left({S}_{yy}-{S}_{xx}\right) tan 2ψ\right| \left(3\right)\end{matrix}$
wherein δ and ψ represent a phase difference which is a birefringence amount derived from a strain and a principal axis azimuth angle, respectively, λ represents a light source wavelength of a photoelasticity measurement apparatus, d represents a sample thickness, n₀ represents a strain-free refractive index with respect to the light source wavelength, |p₁₁ - p₁₂| represents a photoelastic tensor component, and among these, λ, n₀, and |p₁₁ - p₁₂| satisfy the following conditions: $λ = 633 nm ;$ ${n}_{0} = 2.355 ;$ and $\left|{p}_{11}-{p}_{12}\right| = 0.13 .$

6. The gallium nitride substrate according to any one of claims 3 to 5, wherein the main surface has a dislocation density of 5 × 10⁶ cm⁻² or less.

7. The gallium nitride substrate according to any one of claims 1 to 5,
wherein when a normal direction of the main surface is defined as a z direction, and two directions perpendicular to the z direction and perpendicular to each other are defined as an x direction and a y direction, respectively, a fluctuation range of an x-direction component of an off-cut angle on a first line passing through a center of the main surface and extending in the x direction and a fluctuation range of a y-direction component of the off-cut angle on a second line passing through the center of the main surface and extending in the y direction are each 0.2 degrees or less within a section of a length of 40 mm.

8. The gallium nitride substrate according to any one of claims 1 to 5, wherein one or more conditions regarding impurity concentrations are satisfied, the one or more conditions being selected from the following conditions (a) to (c):
condition (a) a Si concentration is 5 × 10¹⁶ atoms/cm³ or more;
condition (b) an O concentration is 3 × 10¹⁶ atoms/cm³ or less, and
condition (c) a H concentration is 1 × 10¹⁷ atoms/cm³ or less.
